# EUROPEAN PATENT APPLICATION

(11) **EP 4 593 061 A1**
(43) Date of publication of application: **30.07.2025**
(21) Application number: 23868069.8
(22) Date of filing: 08.09.2023
(51) Int. Cl.: H01L 21/205, C23C 16/455, C23C 16/509, H01L 21/31, H05H 1/46

(54) **FILM FORMATION DEVICE**

(30) Priority: 22.09.2022 JP 2022151413
(71) Applicant: SCREEN Holdings Co., Ltd., Kyoto-shi, Kyoto 602-8585 (JP)
(72) Inventor: MIYAGI, Masahiro, Kyoto-shi, Kyoto 602-8585 (JP); INABA, Masaki, Kyoto-shi, Kyoto 602-8585 (JP)
(74) Representative: Kilian Kilian & Partner mbB
(86) International application number: PCT/JP2023/032814
(87) International publication number: WO 2024/062946

(57) **Abstract**

A film forming apparatus (100) includes a chamber (1), a mounting table (21), and a fluid head (3). The fluid head (3) is provided at a position facing the first main surface of the substrate (W) placed on the mounting table (21) in the chamber (1). The fluid head (3) includes a plasma chamber (4b), a plasma source (5), a plurality of first outflow ports (4c), a gas flow path (6b), and a plurality of second outflow ports (6c). The plasma source (5) plasmatizes the first source gas in the plasma chamber (4b). The first outflow ports (4c) are two-dimensionally dispersively arrayed in an overlapping region overlapping the first main surface of the substrate W in plan view. The active species derived from the first source gas flows out from the first outflow ports (4c) toward the first main surface of the substrate W. The plurality of second outflow ports (6c) are two-dimensionally dispersively arrayed at positions different from the plurality of first outflow ports (4c) in the overlapping region. The second source gas flows out from the plurality of second outflow ports (6c) toward the first main surface of the substrate W.

## Description

### TECHNICAL FIELD

The present disclosure relates to a film forming apparatus.

### BACKGROUND ART

Conventionally, a metal organic chemical vapor deposition method using plasma has been proposed (for example, Patent Document 1). In the manufacturing apparatus described in Patent Document 1, an organometallic gas of a group III element is supplied into the furnace body while a mixed gas of a nitrogen (N₂) gas and a hydrogen (H₂) gas is plasmatized in the furnace body. As a result, the group III nitride semiconductor film can be formed on the substrate at a relatively low temperature.

In this manufacturing apparatus, a susceptor that supports the substrate is provided in a lower portion in the furnace body. A showerhead electrode is provided in an upper portion of the furnace body. The mixed gas is plasmatized by passing downward through the showerhead electrode, and active species by the plasma are supplied to the substrate. A gas supply pipe for the organometallic gas to flow out is also provided in the furnace body. The gas supply pipe is provided at a height position between the susceptor and the showerhead electrode, and includes a ring portion surrounding the periphery of the susceptor. A plurality of ejection ports are formed inside the ring portion, and the organometallic gas is ejected from the ejection ports toward the inside of the ring portion and supplied to the substrate.

### PRIOR ART DOCUMENT

### PATENT DOCUMENT

Patent Document 1: Japanese Patent No. 6516482

### SUMMARY

### PROBLEM TO BE SOLVED BY THE INVENTION

However, in the technique described in Patent Document 1, since the organometallic gas flows from the outer peripheral side toward the inside of the substrate, the concentration of the organometallic gas tends to be high at the outer peripheral portion and low at the central portion of the substrate. Therefore, it is difficult to perform control for making the film thickness uniform.

Therefore, an object of the present disclosure is to provide a film forming apparatus capable of forming a target film on a substrate with a more uniform film thickness.

### MEANS TO SOLVE THE PROBLEM

A first aspect is a film forming apparatus including: a chamber; a mounting table provided in the chamber and on which a substrate is mounted; and a fluid head provided at a position facing a first main surface of the substrate placed on the mounting table in the chamber, in which the fluid head includes: one or more first inflow port; a plasma chamber into which a first source gas flows through the first inflow port; a plasma source that plasmatizes the first source gas in the plasma chamber; a plurality of first outflow ports that communicate with the plasma chamber, are two-dimensionally dispersively arrayed in an overlapping region overlapping with the first main surface of the substrate in plan view, and allow active species generated by plasmatization of the first source gas to flow out toward the first main surface of the substrate; one or more second inflow port; a gas flow path into which a second source gas flows through the second inflow port and which is partitioned from the plasma chamber; and a plurality of second outflow ports that communicate with the gas flow path, are two-dimensionally dispersively arrayed at positions different from the plurality of first outflow ports in the overlapping region, and allow the second source gas to flow out toward the first main surface of the substrate.

A second aspect is the film forming apparatus according to the first aspect further including a heater that heats the substrate from a second main surface side of the substrate, in which the gas flow path has: a flow path space that is positioned on a side opposite to the mounting table with respect to the plasma chamber and into which the second source gas flows through the second inflow port; and a plurality of through flow paths extending from the flow path space and penetrating the plasma chamber, and the plurality of second outflow ports are respectively formed at tip ends of the plurality of through flow paths.

A third aspect is the film forming apparatus according to the second aspect in which at least a part of the plasma source is provided between the flow path space and the plasma chamber, and is penetrated by the plurality of through flow paths.

A fourth aspect is the film forming apparatus according to the third aspect, in which the plasma source is a surface wave plasma source or a hollow cathode discharge plasma source.

A fifth aspect is the film forming apparatus according to the third or fourth aspect, in which the fluid head further includes a cooling unit that cools the plasma source, and the cooling unit is provided between the flow path space and the plasma source, and is penetrated by the plurality of through flow paths.

A sixth aspect is the film forming apparatus according to any one of the second to fifth aspects, in which the fluid head includes a conductive shield provided between each of the plurality of through flow paths and the plasma chamber.

A seventh aspect is the film forming apparatus according to any one of the second to sixth aspects, in which an opening area of each of the plurality of second outflow ports is smaller than a flow path area of each of the plurality of through flow paths.

An eighth aspect is the film forming apparatus according to any one of the second to seventh aspects, in which the plurality of second outflow ports are located on the mounting table side with respect to the plurality of first outflow ports.

A ninth aspect is the film forming apparatus according to any one of the first to eighth aspects, in which the first inflow port is formed on a side portion of the plasma chamber, and an opening ratio of a first outflow port located in a central region in the overlapping region among the plurality of first outflow ports is greater than an opening ratio of a first outflow port located in an outer peripheral region outside the central region in the overlapping region.

A tenth aspect is the film forming apparatus according to any one of the first to ninth aspects, in which the second inflow port is formed on a side portion of the gas flow path, and an opening ratio of a second outflow port located in a central region in the overlapping region among the plurality of second outflow ports is greater than an opening ratio of a second outflow port located in an outer peripheral region outside the central region in the overlapping region.

An eleventh aspect is the film forming apparatus according to any one of the first to tenth aspects, in which the second inflow port is formed in an upper portion of a central portion of the gas flow path.

A twelfth aspect is the film forming apparatus according to any one of the first to eleventh aspects, including: a first gas supply unit that supplies the first source gas to the fluid head; and a second gas supply unit that supplies the second source gas and an inert carrier gas that conveys the second source gas to the fluid head, in which the second gas supply unit supplies the carrier gas to the fluid head without supplying the second source gas in a predetermined period from a time point at which the plasma source is activated while the first gas supply unit supplies the first source gas, and supplies the second source gas and the carrier gas to the fluid head after a lapse of the predetermined period.

A thirteenth aspect is the film forming apparatus according to any one of the first to twelfth aspects, the first source gas contains a gas having a group 15 element, and the second source gas contains an organometallic gas having a group 13 element.

### EFFECTS OF THE INVENTION

According to the first aspect, the active species derived from the first source gas flows out toward the first main surface of the substrate from the plurality of first outflow ports two-dimensionally dispersively arranged in the overlapping region overlapping the first main surface of the substrate. Therefore, the active species are supplied more uniformly to the first main surface of the substrate. The second source gas flows out toward the first main surface of the substrate from the plurality of second outflow ports two-dimensionally dispersively arranged in a position different from the first outflow port in the overlapping region overlapping the first main surface of the substrate. Therefore, the second source gas is supplied more uniformly to the first main surface of the substrate. Therefore, the target film obtained by the reaction of the active species and the second source gas can be more uniformly formed on the first main surface of the substrate.

According to the second aspect, the flow path space is located on the opposite side of the mounting table with respect to the plasma chamber. Therefore, the flow path space is provided at a position far from the heater. Therefore, the possibility that the second source gas is thermally decomposed in the flow path space can be reduced. As a result, it is possible to suppress precipitation of various components of the second source gas on the inner wall of the flow path space (that is, the inner peripheral surface forming the flow path space) due to thermal decomposition of the second source gas.

Conversely, the plasma chamber is provided at a position closer to the substrate. Therefore, more active species in the plasma chamber reach the first main surface of the substrate before being deactivated. Therefore, the target film can be formed on the first main surface of the substrate with higher efficiency.

According to the third and fourth aspects, plasma can be generated in the plasma chamber with a wider area with respect to the substrate.

According to the fifth aspect, since the cooling unit is close to the plasma source, the plasma source can be effectively cooled. In addition, heat transfer from the plasma source to the flow path space can be suppressed by the cooling unit. Therefore, the possibility that the second source gas is thermally decomposed in the flow path space can be reduced.

According to the sixth aspect, since generation of an electric field for plasma in the through flow path can be suppressed, application of an unnecessary electric field to the second source gas can be suppressed.

According to the seventh and eighth aspects, the distance between the second outflow port and the first outflow port can be increased. Therefore, the possibility that the active species flowing out from the first outflow port reaches the second outflow port can be reduced. Therefore, it is possible to suppress the reaction of the active species and the second source gas in the vicinity of the second outflow port and to suppress the formation of an unnecessary compound film on the inner peripheral surface forming the second outflow port.

According to the ninth aspect, the active species can be caused to flow out from the plurality of first outflow ports more uniformly.

According to the tenth and eleventh aspects, the second source gas can be caused to flow out from the plurality of second outflow ports more uniformly.

According to the twelfth aspect, during a predetermined period that is an initial stage of operation of the plasma source, the second source gas does not flow out from the second outflow port, and the carrier gas flows out from the second outflow port. Although the plasma is unstable during the predetermined period, the second source gas does not flow out from the second outflow port, whereby the film forming processing is not started. Therefore, it is possible to suppress formation of the uneven target film on the first main surface of the substrate. Moreover, since the carrier gas flows out from the second outflow port, the active species flown out from the first outflow port hardly flows into the second outflow port. Therefore, even if the second gas supply unit supplies the second source gas to the fluid head after the lapse of the predetermined period, the reaction between the second source gas and the active species hardly occurs in the gas flow path. Therefore, formation of an unnecessary compound film on the inner peripheral surface constituting the gas flow path can be suppressed.

According to the thirteenth aspect, the group III-V compound semiconductor can be more uniformly formed on the first main surface of the substrate.

### BRIEF DESCRIPTION OF DRAWINGS

[FIG. 1] is a diagram schematically illustrating an example of a configuration of a film forming apparatus according to a first embodiment.
[FIG. 2] is a cross-sectional view schematically illustrating an example of a configuration of a fluid head according to the first embodiment.
[FIG. 3] is a cross-sectional view schematically illustrating an example of a configuration of a fluid head.
[FIG. 4] is an exploded cross-sectional view illustrating an example of a configuration of a fluid head.
[FIG. 5] is a cross-sectional view schematically illustrating an example of a configuration of a plasma source.
[FIG. 6] is a cross-sectional view schematically illustrating an example of a configuration of the plasma source.
[FIG. 7] is a block diagram schematically illustrating an example of a configuration of a control unit.
[FIG. 8] is a diagram schematically illustrating another example of the fluid head according to the first embodiment.
[FIG. 9] is an exploded view schematically illustrating each configuration of the fluid head of FIG. 8.
[FIG. 10] is a view schematically illustrating a cross section taken along line X-X in FIG. 9.
[FIG. 11] is a view schematically illustrating a cross section taken along line XI-XI in FIG. 8.
[FIG. 12] is a cross-sectional view schematically illustrating an example of a configuration of a fluid head according to a second embodiment.
[FIG. 13] is a cross-sectional view schematically illustrating an example of a configuration of a cooling unit.
[FIG. 14] is a cross-sectional view schematically illustrating an example of a configuration of a second flow path member of the fluid head according to the third embodiment.
[FIG. 15] is a cross-sectional view schematically illustrating another example of the configuration of the second flow path member of the fluid head according to the third embodiment.
[FIG. 16] is a cross-sectional view schematically illustrating an example of a configuration of the fluid head according to the third embodiment.
[FIG. 17] is a cross-sectional view schematically illustrating an example of a configuration of a first flow path member of the fluid head according to the third embodiment.
[FIG. 18] is a view schematically illustrating an example of a configuration of a second gas supply unit according to a fourth embodiment.
[FIG. 19] is a flowchart showing an example of an operation of the film forming apparatus according to the fourth embodiment.

### DESCRIPTION OF EMBODIMENT

Hereinafter, embodiments will be described with reference to the accompanying drawings. Note that the drawings are schematically illustrated, and omission of a configuration, simplification of a configuration, or the like is appropriately made in the drawings for convenience of description. In addition, the mutual relationship of sizes and positions of configurations illustrated in the drawings is not necessarily accurately described, and can be appropriately changed.

Furthermore, in the following description, similar constituent elements are denoted by the same reference numerals, and names and functions thereof are also similar. Therefore, detailed description thereof may be omitted in order to avoid duplication.

In addition, in the description described hereinafter, even if ordinal numbers such as "first" or "second" are used, these terms are used for convenience to facilitate understanding of the contents of the embodiments, and the present disclosure is not limited to the order or the like that can be caused by these ordinal numbers.

Where expressions indicating a relative or absolute positional relationship (e.g., "in one direction", "along one direction", "parallel", "orthogonal", "central", "concentric", "coaxial", etc.) are used, the expressions shall not only strictly represent the positional relationship, but also represent a state of being displaced relative to an angle or distance to the extent that a tolerance or a comparable function is obtained, unless otherwise specified. When an expression indicating an equal state (for example, "same", "equal", "homogeneous", or the like) is used, unless otherwise specified, the expression not only represents a quantitatively strictly equal state, but also represents a state in which there is a difference in obtaining a tolerance or a comparable function. In a case where an expression indicating a shape (for example, "quadrangular" or "cylindrical") is used, unless otherwise specified, the expression not only represents the shape geometrically and strictly, but also represents a shape having, for example, unevenness or chamfering within a range in which a comparable effect can be obtained. When the expression "comprising", "provided with", "including" or "having" one constituent element is used, the expression is not an exclusive expression excluding the presence of other components. When the expression "at least any one of A, B, and C" is used, the expression indicates only A, only B, only C, any two of A, B and C, and all of A, B and C.

### <First Embodiment>

### < Outline of Film Forming Apparatus >

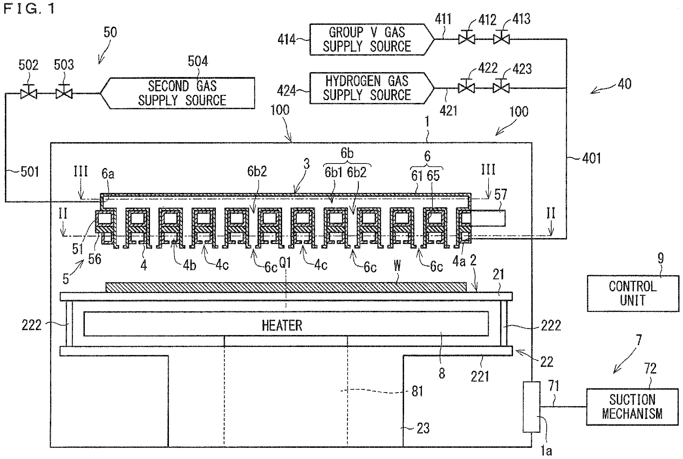

FIG. 1 is a diagram schematically illustrating an example of a configuration of a film forming apparatus 100 according to a first embodiment. The film forming apparatus 100 is an apparatus that forms a target film on the substrate W by a vapor phase growth method using plasma. The target film is a film containing a compound, and is, for example, a group III-V compound semiconductor film containing a group 13 element (hereinafter referred to as group III element) and a group 15 element (hereinafter, referred to as a group V element). When nitrogen is applied as the group V element, this compound semiconductor may be referred to as a group III nitride semiconductor. The group III nitride semiconductor is used, for example, in a lateral transistor.

The substrate W has, for example, a plate shape. The substrate W is, for example, a substrate such as sapphire, silicon carbide, or silicon. The substrate W has, for example, a disk shape. The substrate W has a first main surface and a second main surface opposite to the first main surface. Here, the first main surface is the upper surface of the substrate W, and the second main surface is the lower surface of the substrate W. Since the compound semiconductor film is crystal-grown on the first main surface of the substrate W, the substrate W may also be referred to as a growth substrate. Note that the material and shape of the substrate W are not limited thereto, and can be appropriately changed.

As illustrated in FIG. 1, the film forming apparatus 100 includes a chamber 1, a substrate holder 2, a fluid head 3, and a control unit 9. Hereinafter, each configuration will be outlined, and then a specific example thereof will be described in detail.

The chamber 1 has a box-like hollow shape. The internal space of the chamber 1 corresponds to a processing space for performing film forming processing on the substrate W. The chamber 1 may also be referred to as a vacuum chamber. A shutter or a gate valve (not illustrated) for loading and unloading the substrate W may be provided on the side wall of the chamber 1.

The substrate holder 2 is provided in the chamber 1. The substrate holder 2 includes a susceptor 21 as a mounting table on which the substrate W is to be mounted. The substrate W is placed on the susceptor 21 in a horizontal posture. The horizontal posture as used herein is a posture in which the thickness direction of the substrate W is along the vertical direction.

In the example of FIG. 1, the film forming apparatus 100 is also provided with a suction unit 7. The suction unit 7 suctions the gas in the chamber 1 to lower the pressure in the chamber 1. The suction unit 7 adjusts the pressure in the chamber 1 within a predetermined pressure reduction range suitable for the film forming processing.

In the example of FIG. 1, the film forming apparatus 100 is also provided with a heater 8. The heater 8 is provided in the chamber 1 and heats the substrate W. Specifically, the heater 8 heats the substrate W so that the temperature of the substrate W falls within a temperature range suitable for the film forming processing. In the example of FIG. 1, the heater 8 heats the substrate W from the second main surface (lower surface in this case) side of the substrate W.

The fluid head 3 is provided at a position facing the first main surface (here, the upper surface) of the substrate W on the susceptor 21 in the chamber 1. Here, the fluid head 3 is provided immediately above the substrate W on the susceptor 21. The fluid head 3 causes active species obtained by plasmatizing the first source gas to flow out toward the first main surface of the substrate W, and causes the second source gas to flow out toward the first main surface of the substrate W.

The first source gas contains, for example, a group V gas containing a group V element. The group V element is, for example, nitrogen. In this case, a nitrogen gas can be applied as the group V gas. The first source gas may contain hydrogen gas in addition to nitrogen gas. That is, the first source gas may be a mixed gas of a group V gas and a hydrogen gas. When the first source gas is a mixed gas of nitrogen gas and hydrogen gas, active species such as nitrogen radicals and hydrogen radicals are generated by plasmatization.

The second source gas contains, for example, an organometallic gas containing a group III element. The group III element is, for example, gallium. In this case, TMGa (trimethylgallium), TEGa (triethylgallium), or TDMAGa (trisdimethylamidogallium) can be applied as the organometallic gas.

When the active species derived from the first source gas and the second source gas are supplied to the first main surface of the substrate W, they react with each other, whereby the target film is formed on the first main surface of the substrate W. For example, a group III nitride semiconductor film is formed as the target film.

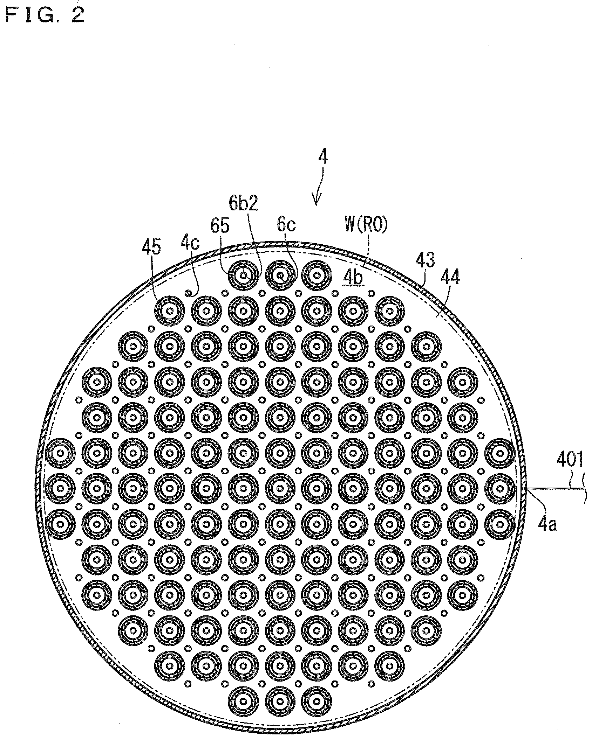

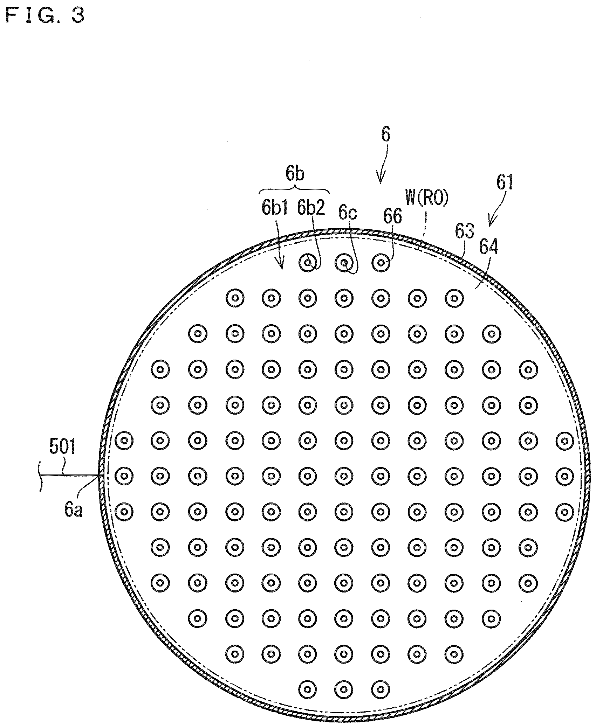

FIGS. 2 and 3 are cross-sectional views schematically illustrating an example of a configuration of a fluid head 3. FIG. 2 illustrates a II-II cross section of FIG. 1, and FIG. 3 illustrates a III-III cross section of FIG. 1.

As illustrated in FIGS. 1 to 3, the fluid head 3 includes a first inflow port 4a, a plasma chamber 4b, a plurality of first outflow ports 4c, a plasma source 5, a second inflow port 6a, a gas flow path 6b, and a plurality of second outflow ports 6c.

As described in detail later, the first source gas flows into the plasma chamber 4b through the first inflow port 4a, and the second source gas flows into the gas flow path 6b through the second inflow port 6a. The plasma chamber 4b and the gas flow path 6b are partitioned from each other inside the fluid head 3. That is, the plasma chamber 4b and the gas flow path 6b do not communicate with each other inside the fluid head 3.

In the examples of FIGS. 1 and 2, the plasma chamber 4b is a flat space whose size in the vertical direction is smaller than the size in the horizontal direction. In the examples of FIGS. 1 and 2, the first inflow port 4a is formed on a side portion of the plasma chamber 4b. The first inflow port 4a is connected to the first gas supply unit 40. The first gas supply unit 40 supplies the first source gas to the plasma chamber 4b through the first inflow port 4a.

The plurality of first outflow ports 4c communicate with the plasma chamber 4b. Specifically, the plurality of first outflow ports 4c are formed in a lower portion of the plasma chamber 4b. The plurality of first outflow ports 4c are two-dimensionally dispersively arranged in the overlapping region R0 overlapping the first main surface of the substrate W in plan view (see also FIG. 2). In FIGS. 2 and 3, the outline of the substrate W in plan view is indicated by a virtual line. In the example of FIG. 2, the plurality of first outflow ports 4c are arranged in a matrix. The plurality of first outflow ports 4c may be dispersively arranged in most of the overlapping region R0. As a more specific example, the plurality of first outflow ports 4c can be dispersively arranged in a circular region having a diameter of equal to or larger than 1/2 the diameter of the substrate W and concentric with the substrate W. In the example of FIG. 2, each first outflow port 4c has a circular shape in plan view.

The plasma source 5 plasma-excites the first source gas in the plasma chamber 4b. In other words, the plasma source 5 plasmatizes the first source gas. In the example of FIG. 1, the plasma source 5 is provided on the side opposite to the susceptor 21 with respect to the plasma chamber 4b. Here, the plasma source 5 is provided vertically above the plasma chamber 4b. The plasma source 5 generates an electric field for plasma in the plasma chamber 4b. When the first source gas passes through the electric field, the electric field acts on the first source gas to plasmatize the first source gas. As a result, active species such as highly reactive ions or neutral radicals are generated in the plasma chamber 4b.

When the first source gas contains hydrogen gas and nitrogen gas, hydrogen radicals and nitrogen radicals are generated as the active species. These active species flow out from the plurality of first outflow ports 4c. The active species from the first outflow port 4c flows toward the first main surface of the substrate W.

The second source gas flows into the gas flow path 6b through the second inflow port 6a. In the examples of FIGS. 1 and 3, the second inflow port 6a is formed on a side portion of the gas flow path 6b. The second inflow port 6a is connected to the second gas supply unit 50. The second gas supply unit 50 supplies the second source gas to the gas flow path 6b through the second inflow port 6a.

In the examples of FIGS. 1 and 3, the gas flow path 6b has a flow path space 6b1 and a plurality of through flow paths 6b2. The flow path space 6b1 is located on the opposite side of the susceptor 21 with respect to both the plasma chamber 4b and the plasma source 5. Here, the flow path space 6b1 is positioned vertically above the plasma source 5. In other words, the plasma source 5 is provided between the flow path space 6b1 and the plasma chamber 4b.

In the examples of FIGS. 1 and 3, the flow path space 6b1 is a flat space whose size in the vertical direction is smaller than the size in the horizontal direction. In the examples of FIGS. 1 and 3, the second inflow port 6a is formed on the side portion of the flow path space 6b1.

The plurality of through flow paths 6b2 extend from the flow path space 6b1 and penetrate the plasma source 5 and the plasma chamber 4b. Here, the through flow path 6b2 extends vertically downward from the flow path space 6b1. The second outflow port 6c is formed at a tip end (here, a lower end) of each through flow path 6b2.

The plurality of second outflow ports 6c communicate with the gas flow path 6b, and are two-dimensionally dispersively arranged at positions different from the plurality of first outflow ports 4c in the overlapping region R0 overlapping the first main surface of the substrate W in plan view. The plurality of second outflow ports 6c are two-dimensionally arranged in plan view, and are arranged in a matrix, for example (see also FIGS. 2 and 3). The plurality of second outflow ports 6c may be dispersively arranged in most of the overlapping region R0. As a more specific example, the plurality of second outflow ports 6c can be dispersively arranged in a circular region having a diameter of equal to or larger than 1/2 the diameter of the substrate W and concentric with the substrate W. In the example of FIGS. 2 and 3, each second outflow port 6c has a circular shape in plan view.

The second source gas flowing into the gas flow path 6b through the second inflow port 6a flows through the gas flow path 6b toward the plurality of second outflow ports 6c, and flows out from the plurality of second outflow ports 6c toward the first main surface of the substrate W.

Since the substrate W is heated by the heater 8, the second source gas supplied to the first main surface of the substrate W is thermally decomposed. The component generated by the thermal decomposition of the second source gas reacts with the active species derived from the first source gas, and the compound is formed as an object film on the first main surface of the substrate W. When the first source gas is a gas containing a nitrogen element and the second source gas is an organometallic gas containing a group III element, the target film is a group III nitride semiconductor film.

The control unit 9 integrally controls the entire film forming apparatus 100. For example, the control unit 9 controls the substrate holder 2, the first gas supply unit 40, the second gas supply unit 50, the plasma source 5, the suction unit 7, and the heater 8.

As described above, in the film forming apparatus 100, the active species derived from the first source gas flows out from the plurality of first outflow ports 4c toward the first main surface of the substrate W, and the second source gas flows out from the plurality of second outflow ports 6c toward the first main surface of the substrate W. Since the plurality of first outflow ports 4c and the plurality of second outflow ports 6c are dispersively arranged in the overlapping region R0 that does not overlap each other and overlaps the first main surface of the substrate W in plan view, the active species and the second source gas are more uniformly supplied to the first main surface of the substrate W. Therefore, the concentration distribution of the active species and the concentration distribution of the second source gas immediately above the substrate W can be made more uniform. Therefore, the active species and the first source gas react with the first main surface of the substrate W in a more uniform distribution. Therefore, the film forming apparatus 100 can form the target film on the first main surface of the substrate W with a more uniform film thickness. When the first source gas contains the group V gas and the second source gas contains the organometallic gas containing the group III element, the film forming apparatus 100 can form the group III-V compound semiconductor film with a more uniform film thickness on the first main surface of the substrate W.

In the above example, the flow path space 6b1 of the gas flow path 6b is located on the opposite side of the susceptor 21 with respect to the plasma chamber 4b. According to this structure, the flow path space 6b1 is located farther than the substrate W and the heater 8 as compared with the structure in which the gas flow path 6b is provided on the susceptor 21 side with respect to the plasma chamber 4b. Therefore, the heat from the heater 8 is less likely to be transmitted to the flow path space 6b1. Therefore, the possibility that the second source gas is thermally decomposed in the flow path space 6b1 can be reduced.

If the second source gas is thermally decomposed in the flow path space 6b1, various components generated by the thermal decomposition are deposited on the inner peripheral surface forming the gas flow path 6b, and the flow path area of the gas flow path 6b is varied. As a result, the uniformity of the flow of the second source gas may be reduced. On the other hand, in the example described above, since the thermal decomposition of the second source gas in the flow path space 6b1 can be suppressed, a non-uniform flow of the second source gas is hardly caused. Therefore, the second source gas flows out more uniformly from the plurality of second outflow ports 6c.

Conversely, the plasma source 5 and the plasma chamber 4b are provided at positions closer to the substrate W than the flow path space 6b1. Therefore, more active species can be supplied to the first main surface of the substrate W. That is, more active species can reach the first main surface of the substrate W before being deactivated. As a result, the film forming apparatus 100 can more efficiently form the target film on the first main surface of the substrate W.

The plasma source 5 is located between the flow path space 6b1 of the gas flow path 6b and the plasma chamber 4b. As a result, the plasma source 5 can be brought close to the plasma chamber 4b, and an electric field for plasma can be easily generated in the plasma chamber 4b. That is, the plasma source 5 can generate an electric field for plasma in the plasma chamber 4b with high efficiency.

Next, a specific example of each configuration will be described in detail.

### <Substrate Holder>

The substrate holder 2 holds the substrate W in a horizontal posture. In the example of FIG. 1, the substrate holder 2 includes a susceptor 21 and a susceptor holder 22. The susceptor 21 is a mounting table on which the substrate W is to be mounted, and has, for example, a flat plate shape. The susceptor 21 is provided in a horizontal posture, and the substrate W is placed on the upper surface of the susceptor 21 in a horizontal posture. The first main surface (here, the upper surface) of the substrate W placed on the susceptor 21 is exposed in the chamber 1.

The susceptor holder 22 is provided in the chamber 1 and holds the susceptor 21. In the example of FIG. 1, the susceptor holder 22 includes a base 221 and a holding protrusion 222. The base 221 is provided vertically below the susceptor 21 and faces the susceptor 21 at an interval in the vertical direction. The base 221 has, for example, a horizontal upper surface, and the holding protrusion 222 is provided upright on the upper surface. For example, a plurality of the holding protrusions 222 are provided and arranged along the peripheral portion of the lower surface of the susceptor 21. The tip end of the holding protrusion 222 is in contact with the susceptor 21 to support or hold the susceptor 21.

As illustrated in FIG. 1, the substrate holder 2 may further include a rotation mechanism 23. The rotation mechanism 23 rotates the susceptor holder 22 about the rotation axis Q1. The rotation axis Q1 is an axis passing through the center portion of the substrate W and extending along the vertical direction. The rotation mechanism 23 includes, for example, a shaft and a motor. The upper end of the shaft is connected to the lower surface of the base 221. The shaft extends along the rotation axis Q1 and is journaled in the chamber 1 rotatably around the rotation axis Q1. The motor rotates the shaft about the rotation axis Q1. As a result, the susceptor holder 22, the susceptor 21, and the substrate W rotate integrally around the rotation axis Q1. Note that the substrate holder 2 may not include the rotation mechanism 23.

### <Heater>

The heater 8 heats the substrate W held by the substrate holder 2 in the chamber 1. In the example of FIG. 1, the heater 8 heats the substrate W from the second main surface (lower surface in this case) side. Specifically, the heater 8 is provided vertically below the susceptor 21 and faces the susceptor 21 in the vertical direction. In the example of FIG. 1, the heater 8 is provided between the susceptor 21 and the base 221, and radially inside the holding protrusion 222. The heater 8 may be, for example, an electric resistance heater including an electric heating wire, or may be an optical heater including a light source that emits light for heating.

Here, the heater 8 is provided so as not to rotate around the rotation axis Q1. That is, the heater 8 does not rotate. For example, the shaft of the rotation mechanism 23 is a hollow shaft, and the heater 8 is fixed to the chamber 1 via a fixing member 81 penetrating the hollow portion.

### <Suction Unit>

The suction unit 7 suctions the gas in the chamber 1. In the example of FIG. 1, the suction unit 7 includes a suction tube 71 and a suction mechanism 72. The upstream end of the suction tube 71 is connected to the exhaust port 1a of the chamber 1. In the example of FIG. 1, the exhaust port 1a is formed vertically below the substrate W held by the substrate holder 2, and is formed, for example, on a side wall of the chamber 1. The suction mechanism 72 is, for example, a pump (more specifically, the vacuum pump), and is connected to the suction tube 71. The suction mechanism 72 is controlled by the control unit 9 and suctions the gas in the chamber 1 through the suction tube 71.

### <First Gas Supply Unit>

The first gas supply unit 40 supplies the first source gas to the fluid head 3. In the example of FIG. 1, the first gas supply unit 40 includes a first gas supply pipe 401, a group V gas supply pipe 411, a hydrogen gas supply pipe 421, a valve 412, a valve 422, a flow rate adjusting unit 413, and a flow rate adjusting unit 423. The downstream end of the first gas supply pipe 401 is connected to the first inflow port 4a of the fluid head 3. The upstream end of the first gas supply pipe 401 is connected to both the downstream end of the group V gas supply pipe 411 and the downstream end of the hydrogen gas supply pipe 421. An upstream end of the group V gas supply pipe 411 is connected to a group V gas supply source 414, and an upstream end of the hydrogen gas supply pipe 421 is connected to a hydrogen gas supply source 424. The group V gas supply source 414 includes a storage unit (not illustrated) that stores the group V gas, and the hydrogen gas supply source 424 includes a storage unit (not illustrated) that stores hydrogen gas.

The valve 412 and the flow rate adjusting unit 413 are inserted into the group V gas supply pipe 411. The valve 412 switches opening and closing of the flow path of the group V gas supply pipe 411. The flow rate adjusting unit 413 adjusts the flow rate of the group V gas flowing through the group V gas supply pipe 411. The flow rate adjusting unit 413 is, for example, a mass flow controller. The valve 422 and the flow rate adjusting unit 423 are inserted into the hydrogen gas supply pipe 421. The valve 422 switches opening and closing of the flow path of the hydrogen gas supply pipe 421. The flow rate adjusting unit 423 adjusts the flow rate of the hydrogen gas flowing through the hydrogen gas supply pipe 421. The flow rate adjusting unit 423 is, for example, a mass flow controller.

### <Second Gas Supply Unit>

The second gas supply unit 50 supplies the second source gas to the fluid head 3. The second gas supply unit 50 includes a second gas supply pipe 501, a valve 502, and a flow rate adjusting unit 503. The downstream end of the second gas supply pipe 501 is connected to the second inflow port 6a. An upstream end of the second gas supply pipe 501 is connected to a second gas supply source 504. The second gas supply source 504 includes a storage unit (not illustrated) that stores the second source gas. The second gas supply source 504 may supply not only the second source gas but also a carrier gas for conveying the second source gas to the upstream end of the second gas supply pipe 501. The carrier gas is an inert gas. As the inert gas, for example, at least one of a rare gas such as an argon gas and a nitrogen gas can be applied. In this case, the second source gas and the carrier gas flow out from the plurality of second outflow ports 6c of the fluid head 3.

### <Fluid Head>

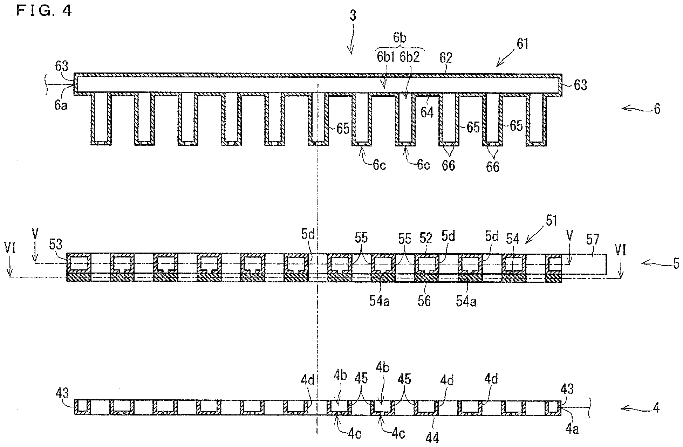

In the example of FIG. 1, the fluid head 3 includes the first flow path member 4, the plasma source 5, and the second flow path member 6. FIG. 4 is an exploded cross-sectional view illustrating an example of a configuration of the fluid head 3. In FIG. 4, the second flow path member 6, the plasma source 5, and the first flow path member 4 are illustrated separately from each other. The first flow path member 4 forms a plasma chamber 4b therein, and the second flow path member 6 forms a gas flow path 6b therein. Hereinafter, the second flow path member 6 will be described, the plasma source 5 will be described, and then the first flow path member 4 will be described.

### <Second Flow Path Member>

In the example of FIG. 4, the second flow path member 6 includes a hollow plate portion 61 and a plurality of vertical pipes 65. The hollow plate portion 61 forms a flow path space 6b1 of the gas flow path 6b, and each of the plurality of vertical pipes 65 forms a plurality of through flow paths 6b2.

The hollow plate portion 61 has a flat shape in which the size in the vertical direction is smaller than the size in the horizontal direction, and includes an upper plate portion 62, a side wall 63, and a lower plate portion 64. The upper plate portion 62 has a flat plate shape, and is provided in a posture in which the thickness direction thereof is along the vertical direction. The upper plate portion 62 has, for example, a circular shape concentric with the substrate W in plan view. The diameter of the upper plate portion 62 may be equal to or larger than the diameter of the substrate W. The lower plate portion 64 has a flat plate shape, and is provided in a posture in which the thickness direction thereof is along the vertical direction. The lower plate portion 64 is positioned vertically lower than the upper plate portion 62 and has, for example, a circular shape concentric with the substrate W in plan view. The diameter of the lower plate portion 64 may be equal to or larger than the diameter of the substrate W. The side wall 63 connects the peripheral edge of the upper plate portion 62 and the peripheral edge of the lower plate portion 64 in the vertical direction. The second inflow port 6a is formed in a part of the side wall 63.

A plurality of through holes are formed in the lower plate portion 64. The upper ends of the plurality of vertical pipes 65 are connected to the lower plate portion 64 such that the upper end openings of the respective vertical pipes 65 coincide with the through holes of the lower plate portion 64. Each of the vertical pipes 65 has a tubular shape and extends downward along the vertical direction from the lower plate portion 64. Each vertical pipe 65 has, for example, a cylindrical shape. As described later, each vertical pipe 65 penetrates the plasma source 5 and the first flow path member 4 along the vertical direction.

In the example of FIG. 4, a distal end portion 66 is provided at the lower end of each vertical pipe 65. The distal end portion 66 has a plate-like shape in which the second outflow port 6c is formed. The distal end portion 66 has, for example, a disk shape, and an outer peripheral edge thereof is connected to a lower end peripheral edge of the vertical pipe 65. The inner peripheral surface of the distal end portion 66 forms the second outflow port 6c. That is, the second outflow port 6c is an opening penetrating the distal end portion 66 in the vertical direction. In such a structure, the diameter of the second outflow port 6c is smaller than the inner diameter of the vertical pipe 65. That is, the opening area of the second outflow port 6c is smaller than the flow path area of the through flow path 6b2. Here, the opening area is the area of the second outflow port 6c on the horizontal plane, and the flow path area is the area of the through flow path 6b2 on the horizontal plane.

### <Plasma Source>

The plasma source 5 is provided closer to the susceptor 21 than the hollow plate portion 61 of the second flow path member 6. More specifically, the plasma source 5 is provided between the hollow plate portion 61 of the second flow path member 6 and the first flow path member 4. That is, the plasma source 5 is provided between the flow path space 6b1 of the gas flow path 6b and the plasma chamber 4b.

Referring also to FIG. 4, the plasma source 5 has a plurality of through holes 5d at positions corresponding to the plurality of vertical pipes 65 of the second flow path member 6 in the vertical direction. The plurality of through holes 5d penetrate the plasma source 5 along the vertical direction. The plurality of vertical pipes 65 pass through the plurality of through holes 5d along the vertical direction. Each through hole 5d has, for example, a circular shape in plan view.

In the example of FIG. 4, the plasma source 5 is a flat plasma source whose size in the vertical direction is smaller than the size in the horizontal direction. As a specific example, the plasma source 5 is a surface wave plasma source that generates surface wave plasma, and includes a waveguide member 51, a dielectric member 56, and a microwave generator 57.

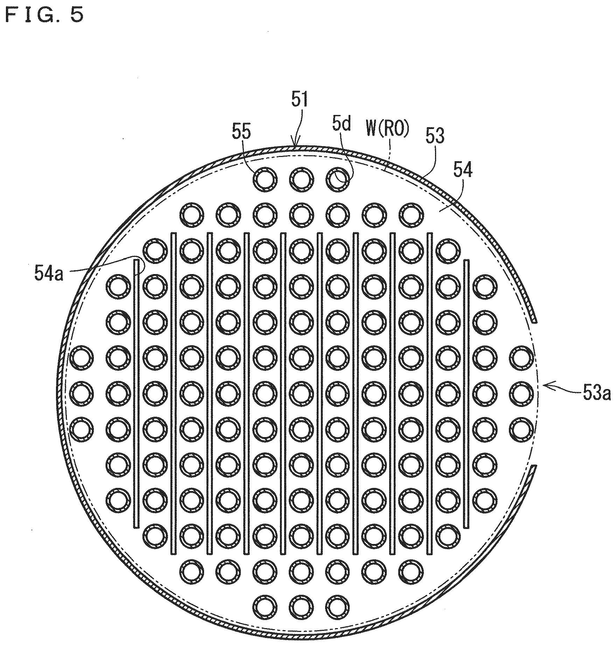

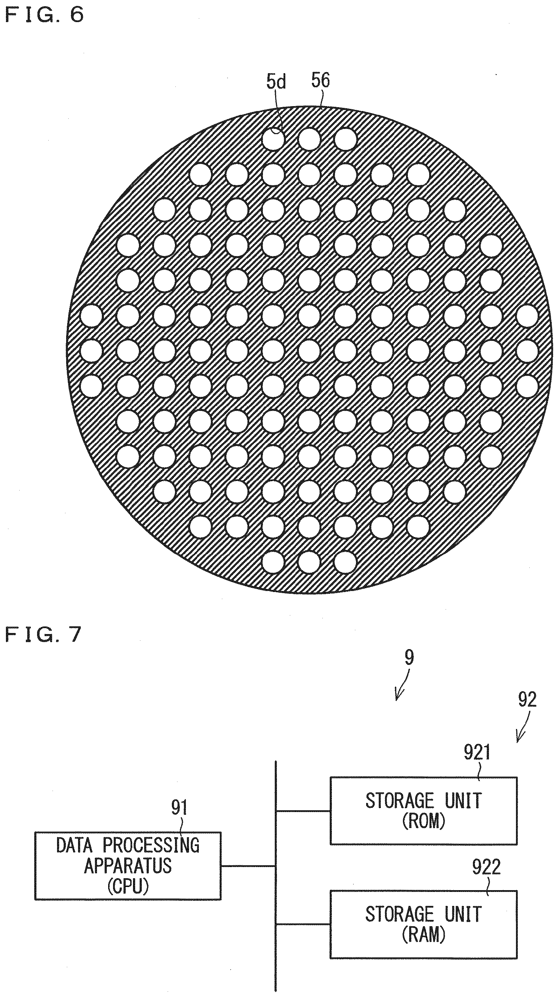

FIGS. 5 and 6 are cross-sectional views schematically illustrating an example of a configuration of the plasma source 5. FIG. 5 illustrates a V-V cross section of FIG. 4, and FIG. 6 illustrates a VI-VI cross section of FIG. 4.

A microwave generator 57 includes an oscillator that oscillates microwaves. The oscillator may be, for example, a magnetron type or solid-state oscillator. The microwave generator 57 is provided outside the substrate W in planar view (see also FIG. 1).

As illustrated in FIGS. 4 and 5, the waveguide member 51 is a hollow member that guides microwaves generated by the microwave generator 57 to the dielectric member 56. The waveguide member 51 is formed of, for example, a conductive member such as metal. In the examples of FIGS. 4 and 5, the waveguide member 51 includes an upper plate portion 52, a side wall 53, a lower plate portion 54, and a plurality of hollow column portions 55. The upper plate portion 52 has a flat plate shape, and is provided in a posture in which the thickness direction thereof is along the vertical direction. The upper plate portion 52 has, for example, a circular shape concentric with the substrate W in plan view. The diameter of the upper plate portion 52 may be equal to or larger than the diameter of the substrate W. The lower plate portion 54 has a flat plate shape, and is provided in a posture in which the thickness direction thereof is along the vertical direction. The lower plate portion 54 is positioned vertically lower than the upper plate portion 52 and has, for example, a circular shape concentric with the substrate W in plan view. The diameter of the lower plate portion 54 may be equal to or larger than the diameter of the substrate W. The side wall 53 connects the peripheral edge of the upper plate portion 52 and the peripheral edge of the lower plate portion 54 in the vertical direction. A connection port 53a connected to an output end of the microwave generator 57 is formed in a part of the side wall 53.

The plurality of hollow column portions 55 are provided between the upper plate portion 52 and the lower plate portion 54. The hollow column portion 55 has a cylindrical shape, specifically, a cylindrical shape as an example. A plurality of through holes through which the plurality of vertical pipes 65 of the second flow path member 6 pass in the vertical direction are formed in the upper plate portion 52 and the lower plate portion 54. Upper ends of the plurality of hollow column portions 55 are connected to the upper plate portion 52 such that upper ends of the plurality of hollow column portions 55 respectively coincide with the plurality of through holes of the upper plate portion 52, and lower ends of the plurality of hollow column portions 55 are connected to the lower plate portion 54 such that lower ends of the plurality of hollow column portions 55 respectively coincide with the plurality of through holes of the lower plate portion 54. That is, the through hole of the upper plate portion 52, the hollow portion of the hollow column portion 55, and the through hole of the lower plate portion 54 communicate with each other in the vertical direction, and constitute an upper portion of the through hole 5d penetrating the plasma source 5.

In addition, a plurality of openings (also referred to as slots) 54a for guiding microwaves to the dielectric member 56 are formed in the lower plate portion 54 of the waveguide member 51. The microwaves from the microwave generator 57 pass through the inside of the waveguide member 51 and are transmitted from each opening 54a to the dielectric member 56. In the example of FIG. 5, the opening 54a has an elongated shape extending along one direction in plan view. The plurality of openings 54a are arranged at intervals in the lateral direction. In the example of FIG. 5, the longitudinal direction of the opening 54a is along the column direction of the matrix in which the plurality of hollow column portions 55 is arranged, and each opening 54a is formed between two adjacent rows.

The dielectric member 56 is provided vertically below the waveguide member 51. The dielectric member 56 is made of a dielectric material (for example, quartz glass). The dielectric member 56 has a flat plate shape, and has, for example, a circular shape concentric with the substrate W in a plan view (see also FIG. 6). The diameter of the dielectric member 56 may be, for example, equal to or larger than the diameter of the substrate W. The upper surface of the dielectric member 56 is entirely in contact with the lower surface (that is, the lower surface of the lower plate portion 54) of the waveguide member 51. The dielectric member 56 has a plurality of through holes formed at positions respectively facing the plurality of hollow column portions 55. Each through hole penetrates the dielectric member 56 along the vertical direction. That is, each through hole of the dielectric member 56 constitutes a lower portion of the corresponding through hole 5d.

Microwaves from the opening 54a of the waveguide member 51 transmit inside the dielectric member 56 and act on the lower surface side of the dielectric member 56. As a result, an electric field for plasma is generated along the lower surface of the dielectric member 56. Since the lower surface of the dielectric member 56 corresponds to the ceiling surface of the plasma chamber 4b as described later, the plasma electric field is generated in the plasma chamber 4b. Therefore, an electric field for plasma acts on the first source gas in the plasma chamber 4b, and the first source gas is plasmatized in the plasma chamber 4b. Since the lower surface of the dielectric member 56 extends in the horizontal direction, the first source gas can be plasmatized in a wide range in plan view.

In the above example, the plasma source 5 generates the surface wave plasma using the microwave, but the present disclosure is not necessarily limited thereto. The plasma source 5 may generate plasma by a so-called capacitive coupling method or an inductive coupling method. Another specific example of the plasma source 5 will be described later.

### <First Flow Path Member>

The first flow path member 4 is provided vertically below the plasma source 5. The first flow path member 4 forms a plasma chamber 4b together with the plasma source 5. In the example of FIG. 4, the first flow path member 4 includes a side wall 43, a lower plate portion 44, and a plurality of hollow column portions 45. The lower plate portion 44 has a flat plate shape, and is provided in a posture in which the thickness direction thereof is along the vertical direction. The lower plate portion 44 has, for example, a circular shape concentric with the substrate W in plan view. The diameter of the lower plate portion 44 may be, for example, equal to or larger than the diameter of the substrate W. The side wall 43 connects the peripheral edge of the lower plate portion 44 and the peripheral edge of the dielectric member 56 of the plasma source 5.

A plurality of through holes through which the plurality of vertical pipes 65 of the second flow path member 6 pass in the vertical direction are formed in the lower plate portion 44, and the lower ends of the plurality of hollow column portions 45 are connected to the lower plate portion 44 such that the lower end ports of the plurality of hollow column portions 45 coincide with the plurality of through holes of the lower plate portion 44. In addition, the upper ends of the plurality of hollow column portions 45 can be connected to the lower surface of the dielectric member 56 such that the upper end ports of the plurality of hollow column portions 45 respectively coincide with the plurality of through holes 5d of the plasma source 5. The hollow portions of the plurality of hollow column portions 45 and the through holes of the lower plate portion 44 correspond to the through holes 4d penetrating the first flow path member 4 along the vertical direction. Each vertical pipe 65 of the second flow path member 6 penetrates each through hole 4d of the first flow path member 4. Each through hole 4d has, for example, a circular shape in plan view.

A plurality of first outflow ports 4c are also formed in the lower plate portion 44. In the example of FIG. 2, the first outflow port 4c and the second outflow port 6c are alternately arranged at equal intervals in the oblique direction. In the example of FIG. 2, in plan view, one first outflow port 4c is located at a midpoint of a diagonal line of a quadrangle having four second outflow ports 6c as vertices. In addition, one second outflow port 6c is located at a midpoint of a diagonal line of a quadrangle having four first outflow ports 4c as vertices.

### <Control Unit>

FIG. 7 is a block diagram schematically illustrating an example of a configuration of the control unit 9. The control unit 9 is an electronic circuit apparatus, and may include, for example, a data processing apparatus 91 and a storage unit 92. The data processing apparatus 91 may be, for example, an arithmetic processing apparatus such as a central processor unit (CPU). The storage unit 92 may include a non-transitory storage unit 921 (for example, a read only memory (ROM) or a hard disk) and a transitory storage unit 922 (for example, a random access memory (RAM)). The non-transitory storage unit 921 may store, for example, a program that defines processing to be executed by the control unit 9. When the data processing apparatus 91 executes this program, the control unit 9 can execute processing defined in the program. Of course, part or all of the processing executed by the control unit 9 may be executed by a hardware circuit such as a logic circuit.

### <Operation of Film Forming Apparatus>

Next, an example of the operation of the film forming apparatus 100 will be outlined. First, an external conveyance apparatus (not illustrated) carries the substrate W into the chamber 1 and passes the substrate W to the substrate holder 2. As a result, the substrate W is placed on the susceptor 21 of the substrate holder 2 in a horizontal posture. Next, the suction unit 7 suctions the gas in the chamber 1 to lower the pressure in the chamber 1 (decompression step). Specifically, the control unit 9 causes the suction mechanism 72 to perform a suction operation. As a result, the gas in the chamber 1 is suctioned by the suction mechanism 72 through the suction tube 71, and the pressure in the chamber 1 decreases. The suction unit 7 adjusts the pressure so that the pressure in the chamber 1 becomes a predetermined process pressure suitable for the film forming processing. The predetermined process pressure is, for example, 100 Pa or more and 500 Pa or less. The suction unit 7 adjusts the pressure in the chamber 1 until the film forming processing is completed.

Next, the heater 8 heats the substrate W (heating step). Specifically, the control unit 9 causes the heater 8 to perform a heating operation. The heater 8 adjusts the temperature of the substrate W so that the temperature of the substrate W becomes a predetermined temperature suitable for the film forming processing. The predetermined temperature is, for example, 600°C or more and 1000°C or less. The heater 8 adjusts the temperature of the substrate W until the film forming processing is completed.

Next, the substrate holder 2 rotates the substrate W around the rotation axis Q1 (rotation step). Specifically, the control unit 9 causes the rotation mechanism 23 to rotate the susceptor holder 22. As a result, the susceptor holder 22, the susceptor 21, and the substrate W rotate integrally around the rotation axis Q1. The substrate holder 2 rotates the substrate W until the film forming processing is completed.

Next, the first gas supply unit 40 supplies the first source gas to the fluid head 3, the second gas supply unit 50 supplies the second source gas to the fluid head 3, and the plasma source 5 plasma-excites the first source gas (film forming step). Specifically, the control unit 9 opens the valve 412, the valve 422, and the valve 502 to cause the microwave generator 57 to generate microwaves. As a result, active species derived from the first source gas flow out from the plurality of first outflow ports 4c of the fluid head 3 toward the first main surface of the substrate W, and the second source gas flows out from the plurality of second outflow ports 6c of the fluid head 3 toward the first main surface of the substrate W.

The second source gas is thermally decomposed on the first main surface of the substrate W, and the component generated by the thermal decomposition reacts with the active species, whereby the target film is formed on the first main surface of the substrate W. As a more specific example, the group III element generated by thermal decomposition of the organometallic gas containing the group III element reacts with the nitrogen radical, and the group III nitride semiconductor is crystal-grown on the first main surface of the substrate W.

When the target film is formed with a predetermined film thickness, the control unit 9 ends the film forming step. Specifically, the control unit 9 closes the valve 412, the valve 422, and the valve 502 to stop microwave output from the microwave generator 57. In addition, the control unit 9 stops the operations of the rotation mechanism 23, the heater 8, and the suction unit 7.

Next, the conveyance apparatus unloads the substrate W from the chamber 1 (unloading step). Specifically, the conveyance apparatus takes out the substrate W placed on the susceptor 21 from the chamber 1.

### <Operation>

As described above, in the film forming step, the active species derived from the first source gas flows out toward the first main surface of the substrate W from the plurality of first outflow ports 4c two-dimensionally dispersively arranged in the overlapping region R0 overlapping the substrate W in plan view. Similarly, the second source also flows out toward the first main surface of the substrate W from the plurality of second outflow ports 6c two-dimensionally dispersively arranged in the overlapping region R0. Therefore, the active species and the second source gas are more uniformly supplied to the first main surface of the substrate W, and as a result, the target film is formed more uniformly on the first main surface of the substrate W.

In addition, since the plasma source 5 illustrated in FIGS. 1 to 6 is a flat plasma source whose size in the horizontal direction is wider than the size in the vertical direction, plasma can be generated more uniformly in a wider range in plan view. The plasma source 5 may generate plasma in a range wider than the overlapping region R0 in plan view. As a result, the active species by the plasma can be more uniformly supplied to the first main surface of the substrate W. As a result, the film forming apparatus 100 can more uniformly form the target film on the first main surface of the substrate W.

In the fluid head 3 illustrated in FIGS. 1 to 6, the second outflow port 6c is formed at the distal end portion 66 of the vertical pipe 65. Therefore, it is possible to reduce the diameter (that is, the opening area) of the second outflow port 6c while increasing the inner diameter (that is, the flow path area of the through flow path 6b2) of the vertical pipe 65. When the inner diameter of the vertical pipe 65 is large, the second source gas easily flows through the vertical pipe 65. On the other hand, since the diameter of the second outflow port 6c is small, the distance between the peripheral edge of the second outflow port 6c and the peripheral edge of the first outflow port 4c can be increased. Therefore, the possibility that the active species flowing out from the first outflow port 4c reaches the second outflow port 6c can be reduced.

If many active species reach the second outflow port 6c, the active species and the second source gas may react with each other, and the compound may be formed on the inner peripheral surface of the distal end portion 66 in the vicinity of the second outflow port 6c. When the opening area of the second outflow port 6c varies due to such a compound film, for example, the flow rate and flow velocity of the second source gas flowing out from the plurality of second outflow ports 6c may vary. This may lead to non-uniformity of the target film on the substrate W. In the above example, since the possibility that the active species flowing out from the first outflow port 4c reaches the second outflow port 6c can be reduced, the possibility that such a problem occurs can be reduced.

In the example of FIG. 1, the vertical pipe 65 penetrates the plasma source 5 and the first flow path member 4, and the distal end portion 66 thereof is positioned vertically lower than the first flow path member 4. That is, each of the second outflow ports 6c formed in the distal end portion 66 is positioned vertically lower than each of the first outflow ports 4c formed in the lower portion of the first flow path member 4. In other words, each of the second outflow ports 6c is located closer to the susceptor 21 than each of the first outflow ports 4c. This also makes it possible to increase the distance between the second outflow port 6c and the first outflow port 4c. Therefore, the possibility that the active species flowing out from the first outflow port 4c reaches the second outflow port 6c can be further reduced.

### <Partition Member>

In the fluid head 3, the plasma chamber 4b and the gas flow path 6b are partitioned from each other. In the above-described example, the plasma chamber 4b and the gas flow path 6b are partitioned from each other by the lower plate portion 64 of the second flow path member 6, the plasma source 5, the vertical pipe 65 of the second flow path member 6, and the hollow column portion 45 of the first flow path member 4. That is, these members function as partition members. However, the present disclosure is not necessarily limited thereto. For example, since the plasma source 5 can function as a partition member that partitions the plasma chamber 4b and the flow path space 6b1 of the gas flow path 6b, the lower plate portion 64 is not necessarily provided. In this case, the lower end peripheral edge of the side wall 63 of the second flow path member 6 can be connected to the plasma source 5. In addition, the vertical pipe 65 and the hollow column portion 45 can function as a partition member that partitions the plasma chamber 4b and the through flow path 6b2 of the gas flow path 6b. Therefore, one of the vertical pipe 65 and the hollow column portion 45 may be omitted. Specifically, for example, a portion of the vertical pipe 65 other than the protruding portion protruding from the first flow path member 4 may be omitted. In this case, the protruding portion can be connected to the first flow path member 4. However, the hollow column portion 45 may be omitted. In this case, the inner peripheral surface of each through hole of the lower plate portion 44 of the first flow path member 4 can be connected to the outer peripheral surface of the corresponding vertical pipe 65.

### <Shield>

The fluid head 3 may include a conductive shield provided at least between the plasma chamber 4b and the through flow path 6b2. For example, at least a portion of each vertical pipe 65 of the second flow path member 6 adjacent to the plasma chamber 4b in the horizontal direction may include a conductive member such as metal. That is, the portion may be made of a conductive material such as metal. The conductive member of each vertical pipe 65 has a tubular shape surrounding the through flow path 6b2. The conductive member can function as a conductive shield that electrically shields the plasma chamber 4b and the through flow path 6b2 from each other.

The conductive member of each vertical pipe 65 may be grounded. Accordingly, the shielding performance can be improved. For example, the entire second flow path member 6 may be made of a conductive member such as metal, and the second flow path member 6 may be grounded through predetermined wiring.

According to such a structure, an electric field for plasma by the plasma source 5 is generated in the plasma chamber 4b, but is less likely to be generated in the vertical pipe 65 (That is, the through flow path 6b2) of the second flow path member 6 by the conductive shield (the conductive member). Since the plasma source 5 generates an electric field for plasma vertically downward, the electric field for plasma is hardly generated in a space adjacent to the plasma source 5 in the horizontal direction and a space in the vertical direction with respect to the plasma source 5. However, when the plasma source 5 generates an electric field in these spaces, the entire second flow path member 6 may be formed of a conductive member. In this case, the entire second flow path member 6 functions as a conductive shield. Therefore, the electric field is less likely to occur in the entire gas flow path 6b, and the electric field is less likely to act on the second source gas. Therefore, it is possible to suppress application of an unnecessary electric field to the second source gas, and it is possible to suppress plasmatization of the second source gas. In addition, when the carrier gas is supplied to the fluid head 3 together with the second source gas, it is also possible to suppress plasmatization of the carrier gas.

### <Other Specific Examples of Fluid Head>

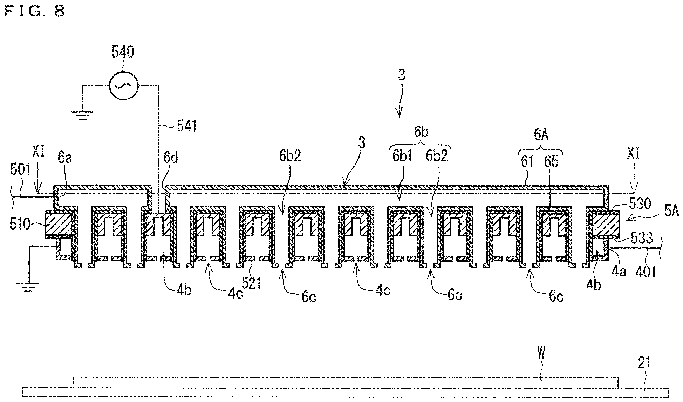

FIG. 8 is a diagram schematically illustrating another example of the fluid head 3 according to the first embodiment. Also in the example of FIG. 8, the fluid head 3 includes a first inflow port 4a, a plasma chamber 4b, a plurality of first outflow ports 4c, a second inflow port 6a, a gas flow path 6b, and a plurality of second outflow ports 6c. However, in the example of FIG. 8, the fluid head 3 includes a plasma source 5A and a flow path member 6A.

The flow path member 6A has the same configuration as the second flow path member 6 except for the presence or absence of the connection port 6d used for supplying power to the plasma source 5A. The connection port 6d will be described later.

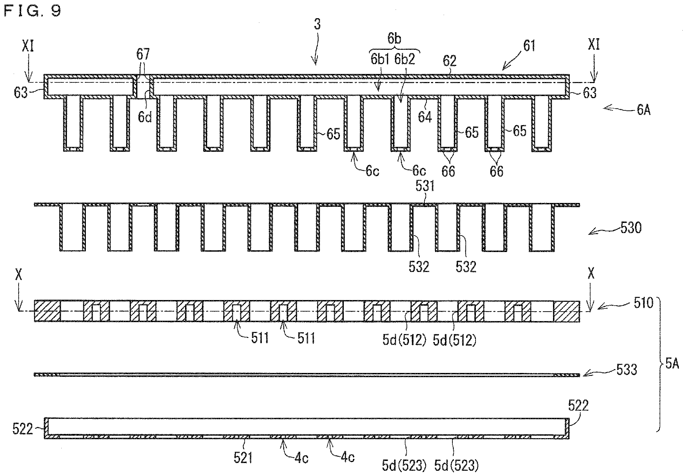

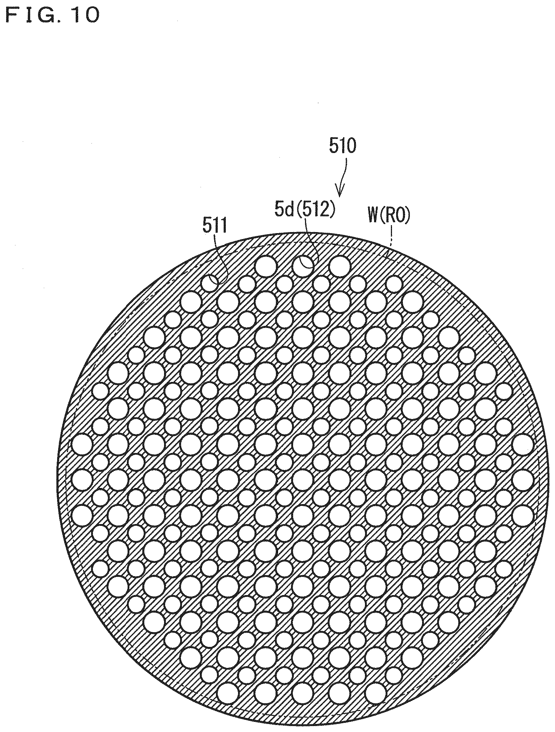

FIG. 9 is an exploded view schematically illustrating each configuration of the fluid head 3 of FIG. 8, and FIG. 10 is a view schematically illustrating a cross section taken along line X-X in FIG. 9. In the example of FIG. 9, the plasma source 5A is a hollow cathode discharge plasma source, and includes a first electrode 510 and a second electrode 521. The first electrode 510 and the second electrode 521 are formed of a conductive member such as metal. As illustrated in FIGS. 9 and 10, the first electrode 510 has a plate shape. In the example of FIG. 10, the first electrode 510 has a circular shape concentric with the substrate W in plan view. The diameter of the first electrode 510 may be equal to or larger than the diameter of the substrate W.

The first electrode 510 is formed with a plurality of through holes 512 through which the plurality of vertical pipes 65 of the flow path member 6A pass. Each through hole 512 penetrates the first electrode 510 along the vertical direction. Each through hole 512 has, for example, a circular shape in plan view.

A plurality of recesses 511 are formed on a surface (lower surface in this case) of the first electrode 510 on the susceptor 21 side. The plurality of recesses 511 are formed at positions different from the through holes 512. In the example of FIG. 10, the plurality of recesses 511 are two-dimensionally dispersively arranged at positions different from the plurality of through holes 512 in the overlapping region R0 overlapping the substrate W in plan view. The plurality of recesses 511 may be dispersively arranged in a region facing most of the overlapping region R0. As a more specific example, the plurality of recesses 511 can be dispersively arranged in a circular region having a diameter of equal to or larger than 1/2 the diameter of the substrate W and concentric with the substrate W.

In the examples of FIGS. 9 and 10, each recess 511 is formed in a columnar shape extending along the vertical direction, and has, for example, a circular shape in plan view. In the example of FIG. 9, the depth of each recess 511 is larger than the thickness between the bottom surface of each recess 511 and the upper surface of the first electrode 510. A portion of the first electrode 510 around each recess 511 constitutes a so-called hollow cathode. That is, the first electrode 510 forms a plurality of hollow cathodes dispersively arranged two-dimensionally in plan view. In the example of FIG. 9, the recess 511 faces the first outflow port 4c on a one-to-one basis in the vertical direction.

The second electrode 521 is located on the susceptor 21 side with respect to the first electrode 510. Here, the second electrode 521 is positioned vertically below the first electrode 510. The second electrode 521 has a plate shape, and has, for example, a circular shape concentric with the substrate W in plan view. The diameter of the second electrode 521 may be equal to or larger than the diameter of the substrate W. The second electrode 521 has, for example, the same shape as the lower plate portion 44 of the first flow path member 4. The second electrode 521 has conductivity and forms a so-called anode.

The second electrode 521 is formed with a plurality of through holes 523 through which the plurality of vertical pipes 65 of the flow path member 6A pass. The through hole 523 penetrates the second electrode 521 along the vertical direction. Each through hole 523 has, for example, a circular shape in plan view. The through hole 512 of the first electrode 510 and the through hole 523 of the second electrode 521 correspond to the through hole 5d penetrating the plasma source 5A.

In the example of FIG. 9, a side wall 522 is provided upright on the peripheral edge of the second electrode 521. The side wall 522 extends from the entire circumference of the peripheral edge of the second electrode 521 toward the first electrode 510. The side wall 522 may be formed integrally with the second electrode 521 using the same material, or may be formed separately from the second electrode 521 using a different material. Here, the side wall 522 is integrally formed of the same material as the second electrode 521.

In the example of FIG. 9, an insulating member 533 is provided between the peripheral edge of the first electrode 510 and the side wall 522. The insulating member 533 ensures insulation between the first electrode 510 and the side wall 522. The insulating member 533 has a plate shape and has a ring shape in plan view. The insulating member 533 can avoid a short circuit between the first electrode 510 and the second electrode 521.

A space surrounded by the first electrode 510, the second electrode 521, and the side wall 522 corresponds to the plasma chamber 4b. That is, the first electrode 510 which is a part of the plasma source 5A is provided between the flow path space 6b1 and the plasma chamber 4b. A first inflow port 4a is formed in a part of the side wall 522, and a plurality of first outflow ports 4c is formed in the second electrode 521. Each of the first outflow ports 4c penetrates the second electrode 521 in the vertical direction.

A plasma voltage is applied between the first electrode 510 and the second electrode 521 by a plasma power supply 540. In the example of FIG. 8, the first output end of the power supply 540 is electrically connected to the first electrode 510, and the second output end of the power supply 540 and the second electrode 521 are grounded. The power supply 540 outputs, for example, a high-frequency voltage. When the voltage is applied between the first electrode 510 and the second electrode 521, an electric field for plasma is generated in the plasma chamber 4b between the first electrode 510 and the second electrode 521, and the first source gas in the plasma chamber 4b is plasmatized. Active species generated by the plasmatization flow out from the plurality of first outflow ports 4c.

Next, the flow path member 6A will be described. Here, as an example, the flow path member 6A is formed of a conductive member. As a result, the flow path member 6A can electrically shield the gas flow path 6b from the outside, and can suppress generation of an electric field for plasma in the gas flow path 6b. When the flow path member 6A has conductivity, as illustrated in FIGS. 8 and 9, the fluid head 3 may be provided with an insulating member 530 that insulates the plasma source 5A from the flow path member 6A. For example, as illustrated in FIG. 9, the insulating member 530 includes a plate portion 531 and a plurality of tubular portions 532. The plate portion 531 has a plate shape and is provided between the hollow plate portion 61 of the flow path member 6A and the first electrode 510 of the plasma source 5A. The plate portion 531 ensures insulation between the hollow plate portion 61 and the first electrode 510. The plate portion 531 has, for example, a circular shape concentric with the substrate W in plan view. The diameter of the plate portion 531 is equal to or larger than the diameters of the hollow plate portion 61 and the first electrode 510. A plurality of through holes are formed in the plate portion 531, and the plurality of vertical pipes 65 of the flow path member 6A pass through the plurality of through holes.

The plurality of tubular portions 532 have a tubular shape, and are connected to the plate portion 531 such that the upper end openings thereof coincide with the respective through holes of the plate portion 531. The plurality of tubular portions 532 extend from the plate portion 531 toward the susceptor 21. The plurality of vertical pipes 65 of the flow path member 6A pass through the plurality of tubular portions 532, respectively. The tubular portion 532 is interposed between the first electrode 510 and the vertical pipe 65 and between the second electrode 521 and the vertical pipe 65. Therefore, the tubular portion 532 can ensure insulation between the first electrode 510 and the vertical pipe 65, and can also ensure insulation between the second electrode 521 and the vertical pipe 65. In other words, a short circuit between the first electrode 510 and the second electrode 521 through the vertical pipe 65 can be avoided.

In the example of FIG. 8, a connection port 6d for a power supply leading to the first electrode 510 is formed in the fluid head 3. The connection port 6d is formed at a position different from the plurality of vertical pipes 65 in plan view, and penetrates the hollow plate portion 61 of the flow path member 6A and the plate portion 531 of the insulating member 530 in the vertical direction. In the example of FIG. 9, the hollow plate portion 61 is also provided with a hollow column portion 67 surrounding the connection port 6d. The hollow column portion 67 has a tubular shape, and connects the upper plate portion 62 and the lower plate portion 64 such that an upper end port thereof coincides with a through hole formed in the upper plate portion 62 and a lower end port thereof coincides with a through hole formed in the lower plate portion 64. The through hole of the upper plate portion 62, the through hole of the hollow column portion 67, and the through hole of the lower plate portion 64 correspond to the upper portion of the connection port 6d.

The first electrode 510 is electrically connected to one end of the wiring 541 at the connection port 6d, and the other end of the wiring 541 is electrically connected to the first output end of the power supply 540.

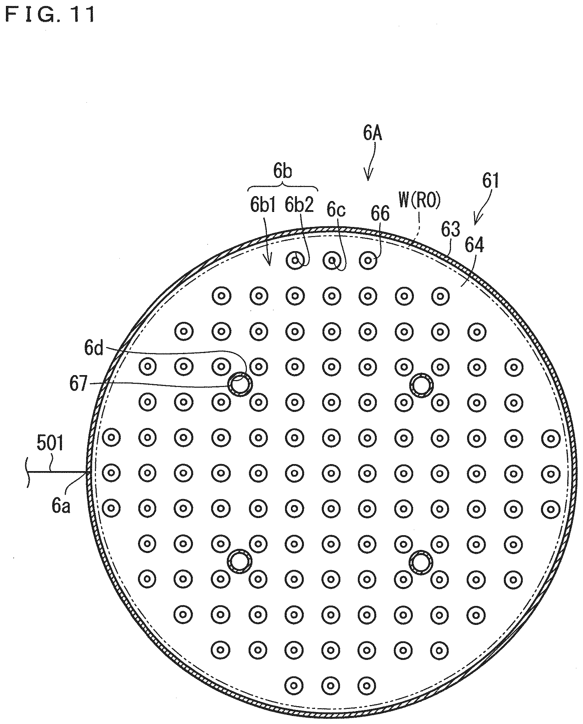

FIG. 11 is a view schematically illustrating a cross section taken along line XI-XI in FIG. 8. As illustrated in FIG. 11, a plurality of connection ports 6d may be formed in the fluid head 3. The plurality of connection ports 6d are formed at different positions in plan view. For example, the plurality of connection ports 6d may be formed at equal intervals in the circumferential direction. In the example of FIG. 8, four connection ports 6d are formed at positions corresponding to respective vertexes of a virtual square.

The first electrode 510 is electrically connected to one end of the wiring 541 at each connection port 6d. Since the first electrode 510 is electrically connected to one ends of the plurality of wirings 541 at the plurality of connection ports 6d, voltages are applied to the first electrode 510 at a plurality of positions. As a result, the voltage distribution (potential distribution) of the first electrode 510 can be made more uniform. As a result, the plasma source 5A can generate plasma more uniformly in plan view.

### <Second Embodiment>

The film forming apparatus 100 according to the second embodiment has the same configuration as that of the first embodiment except for the configuration of the fluid head 3. Hereinafter, the fluid head 3 according to the second embodiment is referred to as a fluid head 3A.

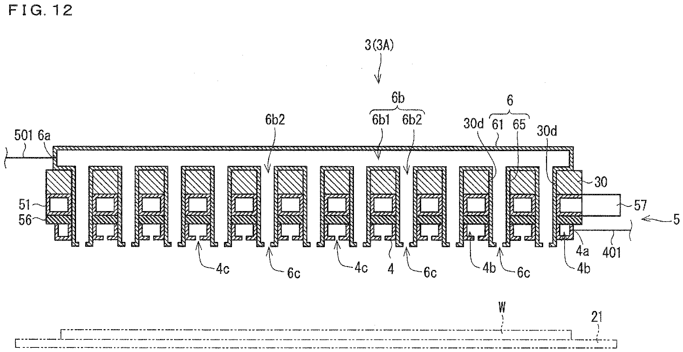

FIG. 12 is a cross-sectional view schematically illustrating an example of a configuration of a fluid head 3A according to a second embodiment. In the example of FIG. 12, the fluid head 3A further includes a first flow path member 4, a plasma source 5, a second flow path member 6, and a cooling unit 30.

The cooling unit 30 cools the plasma source 5. In the example of FIG. 12, the cooling unit 30 is provided between the hollow plate portion 61 of the second flow path member 6 and the plasma source 5. A plurality of through holes 30d through which the plurality of vertical pipes 65 (through flow paths 6b2) of the second flow path member 6 pass are formed in the cooling unit 30.

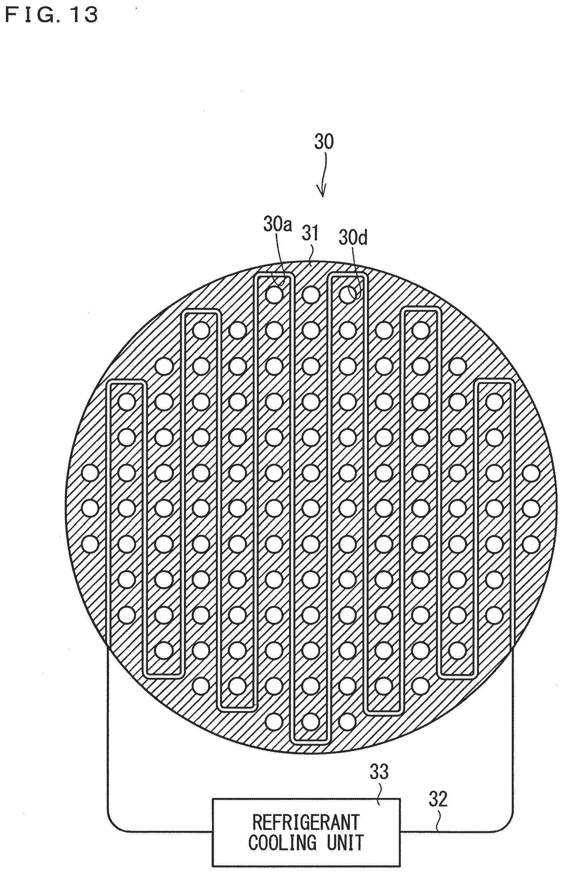

FIG. 13 is a cross-sectional view schematically illustrating an example of a configuration of the cooling unit 30. In the example of FIG. 13, the cooling unit 30 is a refrigerant-type cooling unit, and includes a heat conductive member 31, a refrigerant pipe 32, and a refrigerant cooling unit 33.

The heat conductive member 31 is made of a material having high thermal conductivity, and is made of, for example, metal. The heat conductive member 31 has a plate shape, and is provided in a posture in which the thickness direction is along the vertical direction. The heat conductive member 31 has, for example, a circular shape concentric with the substrate W in plan view. The diameter of the heat conductive member 31 may be, for example, equal to or larger than the diameter of the plasma source 5 (specifically, the waveguide member 51). The heat conductive member 31 may be in close contact with the waveguide member 51 of the plasma source 5.

The heat conductive member 31 has a plurality of through holes 30d and a refrigerant flow path 30a. Each of the plurality of through holes 30d is formed at a position facing the plurality of vertical pipes 65, and penetrates the heat conductive member 31 in the vertical direction. The plurality of vertical pipes 65 of the second flow path member 6 pass through the plurality of through holes 30d of the cooling unit 30, respectively.

In the example of FIG. 13, the upstream end and the downstream end of the refrigerant flow path 30a are formed on the side surface of the heat conductive member 31. The refrigerant flow path 30a extends inside the heat conductive member 31 so as not to interfere with the through hole 30d, and meanders in the example of FIG. 13.

A downstream end of the refrigerant pipe 32 is connected to an upstream end of the refrigerant flow path 30a, and an upstream end of the refrigerant pipe 32 is connected to a downstream end of the refrigerant flow path 30a. The refrigerant such as water flows through the refrigerant pipe 32 and the refrigerant flow path 30a and circulates.

The refrigerant cooling unit 33 cools the refrigerant flowing through the refrigerant pipe 32. The refrigerant cooling unit 33 may be, for example, a heat pump unit. The low-temperature refrigerant cooled by the refrigerant cooling unit 33 exchanges heat with the heat conductive member 31 in the refrigerant flow path 30a. As a result, the refrigerant receives heat from the heat conductive member 31 and cools the heat conductive member 31. Since the heat conductive member 31 exchanges heat with the plasma source 5 and receives heat from the plasma source 5, the plasma source 5 can be cooled. On the other hand, since the refrigerant receives heat from the heat conductive member 31, the temperature of the refrigerant increases. The refrigerant is cooled again in the refrigerant cooling unit 33.

As described above, in the fluid head 3A, the cooling unit 30 cools the plasma source 5. As a result, the temperature rise of the plasma source 5 can be suppressed. Therefore, thermal deterioration occurring in the plasma source 5 and members around the plasma source 5 (for example, the first flow path member 4) can be suppressed.

In the above example, the cooling unit 30 is provided on the opposite side of the susceptor 21 with respect to the plasma source 5. Therefore, the cooling unit 30 does not inhibit generation and supply of active species to the substrate W by the plasma source 5 and the first flow path member 4. In addition, the cooling unit 30 can face the plasma source 5 with a wide area, and can cool the plasma source 5 with a wide area. Therefore, the cooling unit 30 can more effectively cool the plasma source 5.

In addition, since the cooling unit 30 is provided between the hollow plate portion 61 and the plasma source 5, heat conduction from the plasma source 5 to the hollow plate portion 61 can be effectively suppressed. Therefore, the possibility that the second source gas is thermally decomposed in the flow path space 6b1 in the hollow plate portion 61 can be further reduced. The cooling unit 30 may cool the hollow plate portion 61. For example, when the heat conductive member 31 is in close contact with the lower plate portion 64 of the hollow plate portion 61, the cooling unit 30 can effectively cool the hollow plate portion 61.

Note that the cooling unit 30 does not need to be provided between the hollow plate portion 61 and the plasma source 5. For example, the cooling unit 30 may be provided on the side opposite to the plasma source 5 with respect to the hollow plate portion 61, here, vertically above the hollow plate portion 61. Alternatively, the first cooling unit 30 may be provided vertically above the hollow plate portion 61, and the second cooling unit 30 may be provided between the hollow plate portion 61 and the plasma source 5.

In the fluid head 3 of FIG. 8, a cooling unit 30 that cools the plasma source 5A may be provided. For example, the cooling unit 30 can be provided between the hollow plate portion 61 of the flow path member 6A and the plasma source 5A.

### <Third Embodiment>

An example of the configuration of the film forming apparatus 100 according to the third embodiment is similar to that of the first or second embodiment. However, the third embodiment is different from the fluid head 3 according to the first or second embodiment in the configuration of the flow path of the fluid head 3.

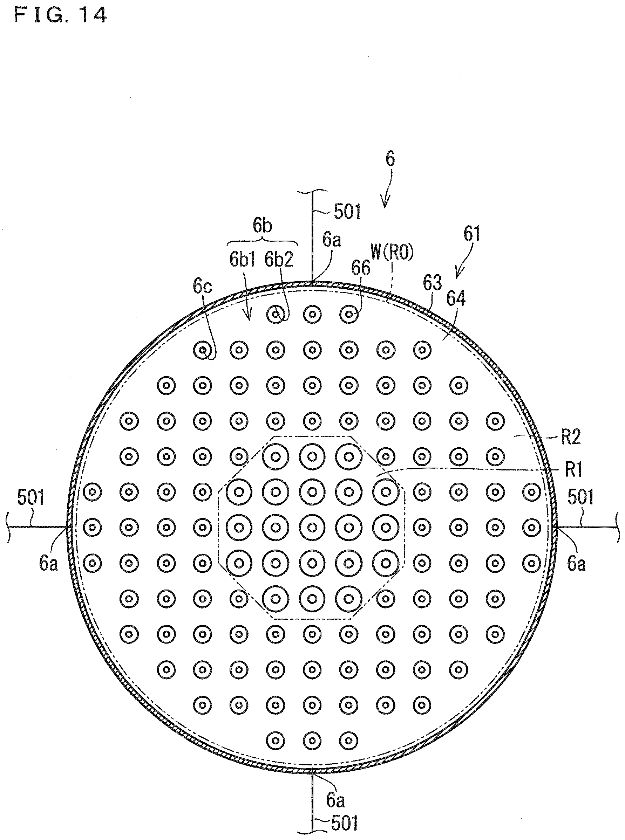

FIG. 14 is a cross-sectional view schematically illustrating an example of a configuration of the second flow path member 6 of the fluid head 3 according to the third embodiment. In the example of FIG. 14, a plurality of second inflow ports 6a are formed in the side wall 63 of the second flow path member 6. The plurality of second inflow ports 6a are formed in the side wall 63 at substantially equal intervals in the circumferential direction. According to this structure, the second source gas flows into the gas flow path 6b (specifically, the flow path space 6b1) from the plurality of second inflow ports 6a. Therefore, the flow of the second source gas in the gas flow path 6b becomes more uniform, and the second source gas flows out more uniformly from the plurality of second outflow ports 6c.

Among the plurality of second outflow ports 6c, the second outflow port 6c on the outer peripheral side is closer to any of the second inflow ports 6a than the second outflow port 6c on the central side. Therefore, from the viewpoint of the length of the flow path of the second source gas, the second source gas easily reaches the second outflow port 6c on the outer peripheral side, and hardly reaches the second outflow port 6c on the central side. That is, from the viewpoint of the length of the flow path, the second source gas easily flows out from the second outflow port 6c on the outer peripheral side, and hardly flows out from the second outflow port 6c on the central side. Therefore, from the viewpoint of the length of the flow path, the second source gas can flow out from the second outflow port 6c on the outer peripheral side at a flow rate slightly larger than that of the second outflow port 6c on the central side.

Therefore, in the example of FIG. 14, the opening area of the second outflow port 6c on the central side is set to be larger than the opening area of the second outflow port 6c on the outer peripheral side. For example, the opening areas of all the second outflow ports 6c in the central region R1 of the overlapping region R0 are larger than the opening areas of all the second outflow ports 6c in the outer peripheral region R2 outside the central region R1 of the overlapping region R0. Therefore, from the viewpoint of the size of the opening area, the second source gas hardly flows out from the second outflow port 6c on the outer peripheral side, and the second source gas easily flows out from the second outflow port 6c on the central side.

Therefore, it is possible to reduce variations in the flow rate of the second source gas flowing out from the second outflow port 6c on the central side and the outer peripheral side. In other words, the second source gas further uniformly flows out from the plurality of second outflow ports 6c.

In the example of FIG. 14, the flow path area of the through flow path 6b2 on the central side among the plurality of through flow paths 6b2 is larger than the flow path area of the through flow path 6b2 on the outer peripheral side. As a more specific example, the flow path areas of all the through flow paths 6b2 in the central region R1 are larger than the flow path areas of all the through flow paths 6b2 in the outer peripheral region R2. In other words, the flow path area of each vertical pipe 65 in the central region R1 is larger than the flow path area of each vertical pipe 65 in the outer peripheral region R2. As a result, it is also possible to reduce variations in the flow rate of the second source gas among the plurality of through flow paths 6b2. As a result, the second source gas further uniformly flows out from the plurality of second outflow ports 6c.

In order to reduce the variation of the second source gas among the plurality of second outflow ports 6c, it is not always necessary to set the opening area of the second outflow port 6c on the central side to be larger than the opening area of the second outflow port 6c on the outer peripheral side. Here, the opening ratio will be described. The opening ratio is the ratio of the sum of the opening areas of the second outflow ports 6c in the predetermined region to the area of the predetermined region. Since the second source gas more easily flows through the second outflow port 6c as the opening ratio is larger, the opening ratio of the second outflow port 6c on the central side may be made larger than the opening ratio of the second outflow port 6c on the outer peripheral side.

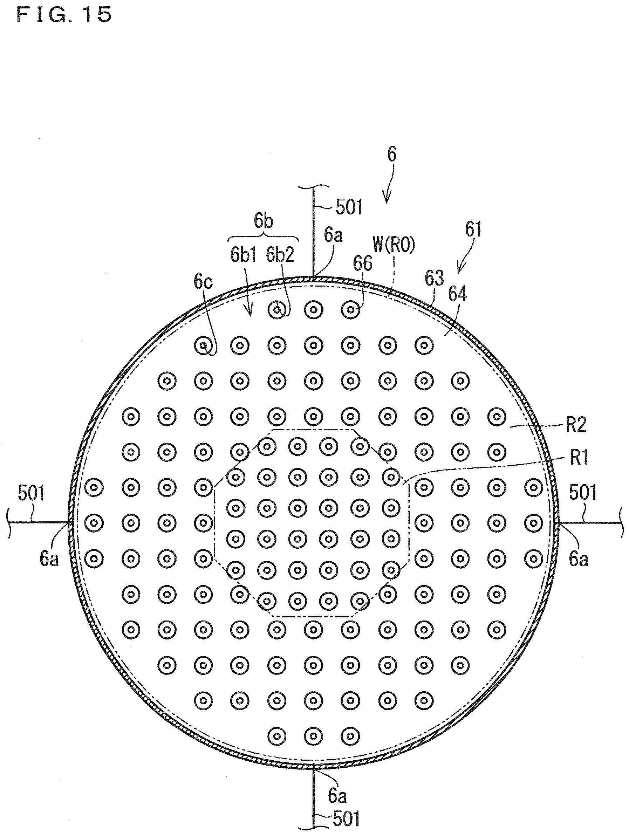

FIG. 15 is a cross-sectional view schematically illustrating another example of the configuration of the second flow path member 6 of the fluid head 3 according to the third embodiment. In the example of FIG. 15, the pitch between the second outflow ports 6c located in the central region R1 is narrower than the pitch between the second outflow ports 6c located in the outer peripheral region R2. Therefore, the opening ratio of the second outflow port 6c in the central region R1 is larger than the opening ratio of the second outflow port 6c in the outer peripheral region R2. Therefore, it is possible to reduce variations in the flow rate of the second source gas flowing out from the second outflow port 6c on the central side and the outer peripheral side. In other words, the second source gas further uniformly flows out from the plurality of second outflow ports 6c.

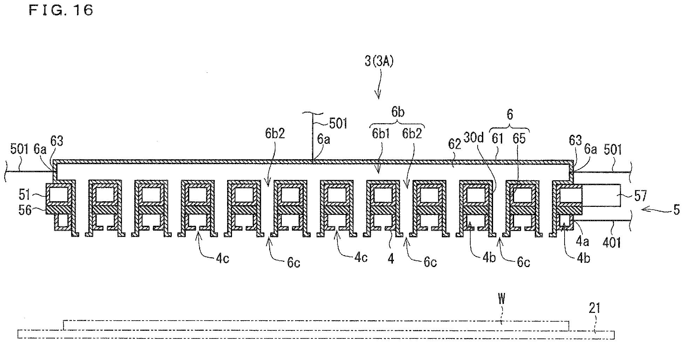

FIG. 16 is a cross-sectional view schematically illustrating an example of a configuration of the fluid head 3 according to the third embodiment. In the example of FIG. 16, the second inflow port 6a is formed not only in the side wall 63 of the second flow path member 6 but also in the upper plate portion 62. Specifically, the second inflow port 6a is formed in the central portion of the upper plate portion 62. In other words, the second inflow port 6a is formed in the upper portion of the central portion of the flow path space 6b1. The second inflow port 6a of the upper plate portion 62 is formed, for example, at a position aligned with the center of the substrate W in the vertical direction.

According to this structure, the second source gas flows into the gas flow path 6b (more specifically, the flow path space 6b1) not only from the plurality of second inflow ports 6a on the side portion but also from the second inflow port 6a above the central portion. Therefore, the flow of the second source gas in the flow path space 6b1 of the gas flow path 6b can be further uniformized. Therefore, the second source gas further uniformly flows out from the plurality of second outflow ports 6c.

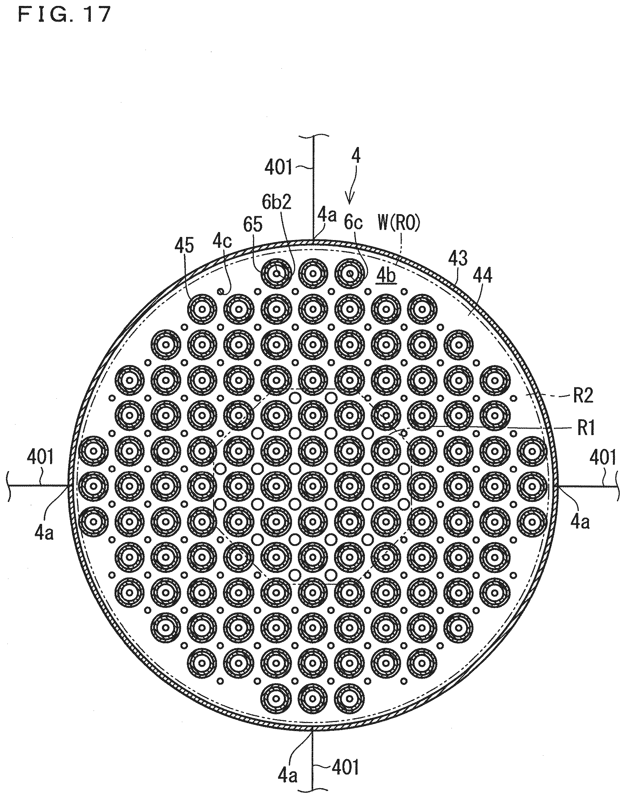

The opening ratio of the first outflow port 4c may also be set in the same manner as the second outflow port 6c. FIG. 17 is a cross-sectional view schematically illustrating an example of a configuration of the first flow path member 4 of the fluid head 3 according to the third embodiment. In the example of FIG. 17, a plurality of first inflow ports 4a are formed in the side wall 43 of the first flow path member 4. The plurality of first inflow ports 4a are formed in the side wall 43 at substantially equal intervals in the circumferential direction. According to this structure, the first source gas flows into the plasma chamber 4b from the plurality of first inflow ports 4a. Therefore, the flow of the first source gas in the plasma chamber 4b becomes more uniform, and the active species derived from the first source gas more uniformly flows out from the plurality of first outflow ports 4c.

In the example of FIG. 17, the opening ratio of the first outflow port 4c on the central side is set to be larger than the opening ratio of the first outflow port 4c on the outer peripheral side. For example, in plan view, the opening areas of all the first outflow ports 4c in the central region R1 are larger than the opening areas of all the first outflow ports 4c in the outer peripheral region R2. Therefore, from the viewpoint of the size of the opening area, the active species derived from the first source gas is less likely to flow out from the first outflow port 4c on the outer peripheral side, and the active species is likely to flow out from the first outflow port 4c on the central side. Therefore, it is possible to reduce variations in the flow rate of the active species flowing out from the first outflow port 4c on the central side and the outer peripheral side. In other words, the active species more uniformly flow out from the plurality of first outflow ports 4c.

The pitch of the first outflow port 4c on the central side may be set narrower than the pitch of the first outflow port 4c on the outer peripheral side.

Although the fluid head 3 including the first flow path member 4, the plasma source 5, and the second flow path member 6 has been described in the above example, the same applies to the fluid head 3 including the plasma source 5A and the flow path member 6A.

### <Fourth Embodiment>

An example of the configuration of the film forming apparatus 100 according to the fourth embodiment is similar to the configuration of any of the first to third embodiments. However, in the fourth embodiment, the configuration of the second gas supply unit 50 is different from that of the second gas supply unit 50 according to the first to third embodiments. The second gas supply unit 50 can switch between a state in which both the second source gas and the carrier gas are supplied to the fluid head 3 and a state in which the carrier gas is supplied to the fluid head 3 without supplying the second source gas. The carrier gas here is a gas for conveying the second source gas, and is an inert gas. As the inert gas, for example, at least one of a rare gas such as an argon gas and a nitrogen gas can be applied.

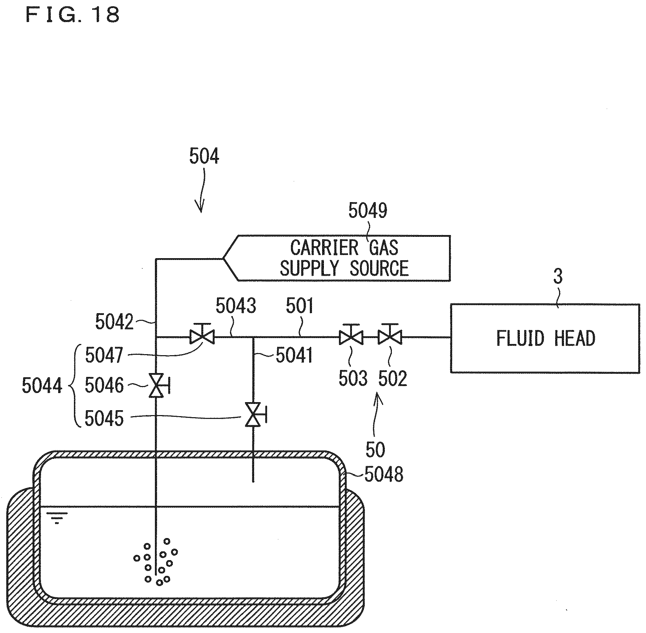

FIG. 18 is a view schematically illustrating an example of a configuration of a second gas supply unit 50 according to a fourth embodiment. In the example of FIG. 18, the second gas supply source 504 includes a gas supply pipe 5041, a gas supply pipe 5042, a bypass pipe 5043, a switching unit 5044, and a thermostatic bath 5058.

The thermostatic bath 5058 is a sealed container, and stores a liquid (hereinafter, referred to as a second source liquid) of the second source gas. The thermostatic bath 5058 includes a heat source, and the heat source heats the second source liquid. As a result, the evaporation of the second source liquid can be promoted, and the space in the thermostatic bath 5058 vertically above the second source liquid is filled with the second source gas.

An upstream end of the gas supply pipe 5041 is connected to the thermostatic bath 5058. Specifically, the upstream end of the gas supply pipe 5041 opens vertically above the second source liquid in the thermostatic bath 5058. A downstream end of the gas supply pipe 5041 is connected to an upstream end of the second gas supply pipe 501.

A downstream end of the gas supply pipe 5042 is connected to the thermostatic bath 5058. In the example of FIG. 18, the downstream end of the gas supply pipe 5042 is immersed in the second source liquid inside the thermostatic bath 5058. That is, the downstream end of the gas supply pipe 5042 is opened in the second source liquid. An upstream end of the gas supply pipe 5042 is connected to a carrier gas supply source 5049. The carrier gas supply source 5049 includes a storage unit (not illustrated) that stores the carrier gas.

The upstream end of the bypass pipe 5043 is connected to the middle of the gas supply pipe 5042, and the downstream end of the bypass pipe 5043 is connected to the upstream end of the second gas supply pipe 501.

The switching unit 5044 is controlled by the control unit 9 to switch between a first connection state and a second connection state to be described next. The first connection state is a connection state in which the carrier gas from the carrier gas supply source 5049 is supplied to the upstream end of the second gas supply pipe 501 through the gas supply pipe 5042, the thermostatic bath 5058, and the gas supply pipe 5041. In the first connection state, the carrier gas flows into the thermostatic bath 5058. Therefore, the second source gas and the carrier gas inside the thermostatic bath 5058 flow into the upstream end of the second gas supply pipe 501 through the gas supply pipe 5041. Therefore, in the first connection state, the second source gas and the carrier gas are supplied to the fluid head 3 through the second gas supply pipe 501. Therefore, the second source gas and the carrier gas flow out from the plurality of second outflow ports 6c of the fluid head 3 toward the first main surface of the substrate W.

The second connection state is a connection state in which the carrier gas from the carrier gas supply source 5049 is supplied to the upstream end of the second gas supply pipe 501 through the bypass pipe 5043. In the second connection state, the carrier gas bypasses the thermostatic bath 5058 and flows into the upstream end of the second gas supply pipe 501. Therefore, in the second connection state, the second source gas is not supplied to the fluid head 3, and the carrier gas is supplied to the fluid head 3. Therefore, only the carrier gas flows out from the plurality of second outflow ports 6c of the fluid head 3 toward the first main surface of the substrate W.

In the example of FIG. 18, the switching unit 5044 includes a valve 5045, a valve 5046, and a valve 5047. The valve 5045 is inserted into the gas supply pipe 5041, the valve 5046 is inserted into a portion of the gas supply pipe 5042 between the bypass pipe 5043 and the thermostatic bath 5058, and the valve 5047 is inserted into the bypass pipe 5043. When the valve 5047 is closed and the valve 5045 and the valve 5046 are opened, the switching unit 5044 can realize the first connection state. When the valve 5047 is opened and the valve 5045 and the valve 5046 are closed, the switching unit 5044 can realize the second connection state.

### <Operation of Film Forming Apparatus>

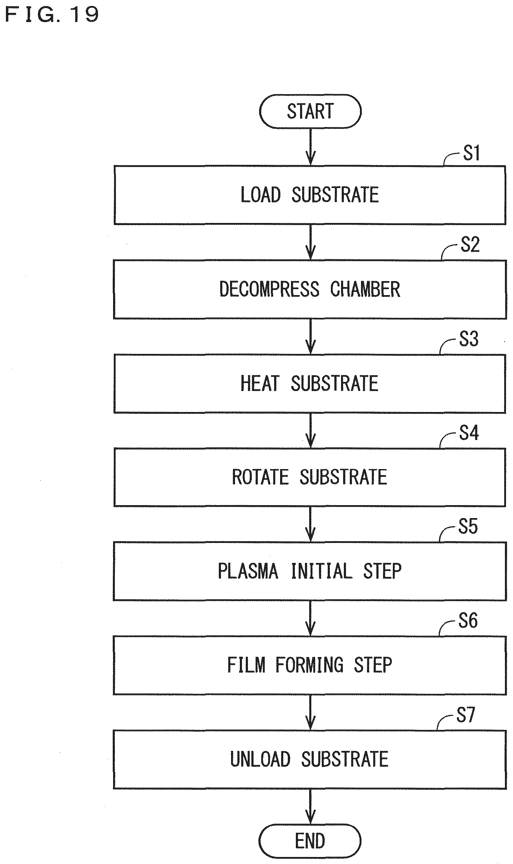

Next, an example of the operation of the film forming apparatus 100 according to the fourth embodiment will be described. FIG. 19 is a flowchart showing an example of an operation of the film forming apparatus 100 according to the fourth embodiment. That is, FIG. 19 is a flowchart showing an example of a film forming method.

First, the substrate W is conveyed into the chamber 1 by an external conveyance apparatus (step S1: loading step). As a result, the substrate W is placed on the susceptor 21 in a horizontal posture. Next, the suction unit 7 suctions the gas in the chamber 1 to lower the pressure in the chamber 1 (step S2: decompression step), and the heater 8 heats the substrate W (step S3: heating step). Next, the substrate holder 2 rotates the substrate W around the rotation axis Q1 (step S4: rotation step). The pressure adjustment of the chamber 1 by the suction unit 7, the temperature adjustment of the substrate W by the heater 8, and the rotation of the substrate W by the substrate holder 2 can be continued until the film forming processing is completed.

Next, the first gas supply unit 40 supplies the first source gas to the fluid head 3, the second gas supply unit 50 supplies the carrier gas to the fluid head 3 without supplying the second charge gas, and the plasma source 5 generates an electric field for plasma (step S5: plasma initial step). Specifically, first, the control unit 9 causes the switching unit 5044 to realize the second connection state and opens the valve 502. As a result, the second gas supply unit 50 supplies the carrier gas to the fluid head 3 without supplying the second source gas. Therefore, the second source gas does not flow out from the plurality of second outflow ports 6c of the fluid head 3, and the carrier gas flows out from the plurality of second outflow ports 6c. In addition, the control unit 9 opens the valve 412 and the valve 422. As a result, the first gas supply unit 40 supplies the first source gas containing nitrogen gas and hydrogen gas to the fluid head 3. Therefore, the first source gas flows into the plasma chamber 4b of the fluid head 3. Since the control unit 9 generates an electric field for plasma in the plasma source 5, the first source gas is plasmatized in the plasma chamber 4b. Active species generated by this plasmatization flow out from the plurality of first outflow ports 4c.

Immediately after the start of the operation of the plasma source 5, the plasma is not stabilized. That is, immediately after the start of the operation of the plasma source 5, plasma may be locally generated without being spatially uniform in plan view. Therefore, in the plasma initial step, the second gas supply unit 50 supplies the carrier gas to the fluid head 3 without still supplying the second source gas to the fluid head 3. Therefore, in the plasma initial step, the formation of the target film on the first main surface of the substrate W is not started until the plasma is stabilized, while the plasmatization of the first source gas is started.

In the plasma initial step, since the carrier gas flows out from the second outflow port 6c of the fluid head 3, it is possible to suppress the active species flowing out from the first outflow port 4c from flowing into the gas flow path 6b through the second outflow port 6c. That is, it is possible to suppress mixing of unnecessary active species into the gas flow path 6b. If the active species are mixed in the gas flow path 6b, when the second source gas flows into the gas flow path 6b in the next step (film forming step) described later, the second source gas may react with the active species, and an unnecessary substance may precipitate on the inner wall of the second flow path member 6. Such precipitation is not preferable because it causes a variation in the flow path area of the gas flow path 6b.

On the other hand, in the fourth embodiment, the carrier gas flows out from the second outflow port 6c in the plasma initial step. Therefore, it is possible to suppress the fluctuation of the flow path area of the gas flow path 6b.

When a predetermined period has elapsed from the start of the plasma initial step, the second gas supply unit 50 supplies the second source gas and the carrier gas to the fluid head 3 (step S6: film forming step). The predetermined period is a period equal to or longer than a period required for stabilizing the plasma, and is set in advance, for example. That is, the second gas supply unit 50 starts supplying the second source gas after the plasma is stabilized. More specifically, the control unit 9 causes the switching unit 5044 to realize the first connection state. As a result, since the second gas supply unit 50 supplies the second source gas and the carrier gas to the fluid head 3, the second source gas and the carrier gas flow out from the plurality of second outflow ports 6c of the fluid head 3.

That is, in the film forming step, the fluid head 3 causes the second source gas to flow out more uniformly from the plurality of second outflow ports 6c while causing the active species to flow out more uniformly from the plurality of first outflow ports 4c. The second source gas is thermally decomposed on the first main surface of the substrate W, and the component generated by the thermal decomposition reacts with the active species, whereby the target film is formed on the first main surface of the substrate W.

In the film forming step, when the target film is formed with a predetermined film thickness, the control unit 9 ends the film forming step. Specifically, the control unit 9 closes the valve 412 of the first gas supply unit 40, the valve 422, and the valve 502 of the second gas supply unit 50, and stops the operation of the plasma source 5. In addition, the control unit 9 stops the operations of the rotation mechanism 23, the heater 8, and the suction unit 7.

Next, the conveyance apparatus transports the substrate W out of the chamber 1 (step S7: unloading step). Specifically, the external conveyance apparatus takes out the substrate W placed on the susceptor 21 from the chamber 1.

As described above, in the fourth embodiment, the second gas supply unit 50 supplies the carrier gas to the fluid head 3 without supplying the second source gas in a predetermined period from a time point at which the plasma source 5 is activated while the first gas supply unit 40 supplies the first source gas (plasma initial step), and supplies the second source gas and the carrier gas to the fluid head 3 after a lapse of the predetermined period (film forming step). For this reason, in a predetermined period in which the plasma is not stable, the film forming processing of the target film on the first main surface of the substrate W is not started, and non-uniformity of the film thickness of the target film can be suppressed. Moreover, since the carrier gas flows out from the second outflow port 6c in the predetermined period, it is also possible to suppress the inflow of the active species flowing out from the first outflow port 4c into the second outflow port 6c.

As described above, although the film forming apparatus 100 has been described in detail, the above description is an example in all aspects, and the film forming apparatus 100 is not limited thereto. It is understood that numerous modifications not illustrated can be assumed without departing from the scope of the present disclosure. The configurations described in the above embodiments and modifications can be appropriately combined or omitted as long as they do not contradict each other.

For example, in the above example, a gas containing a group V element was applied as the first source gas, and an organometallic gas containing a group III element was applied as the second source gas. Thus, the film forming apparatus 100 can form the group III-V compound semiconductor film as the target film on the first main surface of the substrate W. However, the present disclosure is not necessarily limited thereto. For example, oxygen gas may be applied as the first source gas, and silane gas may be applied as the second source gas. As a result, the film forming apparatus 100 can form the silicon oxide film as the target film on the first main surface of the substrate W.

### EXPLANATION OF REFERENCE SIGNS

1: chamber
100: film forming apparatus
21: mounting table (susceptor)
3, 3A: fluid head
30: cooling unit
40: first gas supply unit
4a: first inflow port
4b: plasma chamber
4c: first outflow port
5, 5A: plasma source
50: second gas supply unit
65: conductive shield (vertical pipe)
6a: second inflow port
6b: gas flow path
6b1: flow path space
6b2: through flow path
6c: second outflow port
8: heater
R0: overlapping region
R1: central region
R2: outer peripheral region
W: substrate

## Claims

1. A film forming apparatus comprising:
a chamber;
a mounting table provided in said chamber and on which a substrate is mounted; and
a fluid head provided at a position facing a first main surface of said substrate placed on said mounting table in said chamber,
wherein said fluid head includes:
one or more first inflow port;
a plasma chamber into which a first source gas flows through said first inflow port;
a plasma source that plasmatizes said first source gas in said plasma chamber;
a plurality of first outflow ports that communicate with said plasma chamber, are two-dimensionally dispersively arrayed in an overlapping region overlapping with said first main surface of said substrate in plan view, and allow active species generated by plasmatization of said first source gas to flow out toward said first main surface of said substrate;
one or more second inflow port;
a gas flow path into which a second source gas flows through said second inflow port and which is partitioned from said plasma chamber; and
a plurality of second outflow ports that communicate with said gas flow path, are two-dimensionally dispersively arrayed at positions different from said plurality of first outflow ports in said overlapping region, and allow said second source gas to flow out toward said first main surface of said substrate.

2. The film forming apparatus according to claim 1, further comprising a heater that heats said substrate from a second main surface side of said substrate,
wherein
said gas flow path has:
a flow path space that is positioned on a side opposite to said mounting table with respect to said plasma chamber and into which said second source gas flows through said second inflow port; and
a plurality of through flow paths extending from said flow path space and penetrating said plasma chamber, and
said plurality of second outflow ports are respectively formed at tip ends of said plurality of through flow paths.

3. The film forming apparatus according to claim 2, wherein at least a part of said plasma source is provided between said flow path space and said plasma chamber, and is penetrated by said plurality of through flow paths.

4. The film forming apparatus according to claim 3, wherein said plasma source is a surface wave plasma source or a hollow cathode discharge plasma source.

5. The film forming apparatus according to claim 3 or 4, wherein
said fluid head further includes a cooling unit that cools said plasma source, and
said cooling unit is provided between said flow path space and said plasma source, and is penetrated by said plurality of through flow paths.

6. The film forming apparatus according to any one of claims 2 to 4, wherein said fluid head includes a conductive shield provided between each of said plurality of through flow paths and said plasma chamber.

7. The film forming apparatus according to any one of claims 2 to 4, wherein an opening area of each of said plurality of second outflow ports is smaller than a flow path area of each of said plurality of through flow paths.

8. The film forming apparatus according to any one of claims 2 to 4, wherein said plurality of second outflow ports are located on said mounting table side with respect to said plurality of first outflow ports.

9. The film forming apparatus according to any one of claims 1 to 4, wherein
said first inflow port is formed on a side portion of said plasma chamber, and
an opening ratio of a first outflow port located in a central region in said overlapping region among said plurality of first outflow ports is greater than an opening ratio of a first outflow port located in an outer peripheral region outside said central region in said overlapping region.

10. The film forming apparatus according to any one of claims 1 to 4, wherein
said second inflow port is formed on a side portion of said gas flow path, and
an opening ratio of a second outflow port located in a central region in said overlapping region among said plurality of second outflow ports is greater than an opening ratio of a second outflow port located in an outer peripheral region outside said central region in said overlapping region.

11. The film forming apparatus according to any one of claims 1 to 4, wherein said second inflow port is formed in an upper portion of a central portion of said gas flow path.

12. The film forming apparatus according to any one of claims 1 to 4, comprising:
a first gas supply unit that supplies said first source gas to said fluid head; and
a second gas supply unit that supplies said second source gas and an inert carrier gas that conveys said second source gas to said fluid head,
wherein said second gas supply unit supplies said carrier gas to said fluid head without supplying said second source gas in a predetermined period from a time point at which said plasma source is activated while said first gas supply unit supplies said first source gas, and supplies said second source gas and said carrier gas to said fluid head after a lapse of said predetermined period.

13. The film forming apparatus according to any one of claims 1 to 4, wherein
said first source gas contains a gas having a group 15 element, and
said second source gas contains an organometallic gas having a group 13 element.
